# EUROPEAN PATENT APPLICATION

(11) **EP 4 617 777 A1**
(43) Date of publication of application: **17.09.2025**
(21) Application number: 23888514.9
(22) Date of filing: 26.10.2023
(51) Int. Cl.: G03F 7/26, G03F 7/004, G03F 7/32, H01L 21/027, H01L 21/31, H01L 21/312

(54) **SUBSTRATE PROCESSING METHOD, COMPOSITION FOR FORMING METAL-CONTAINING RESIST, METAL-CONTAINING RESIST, AND SUBSTRATE PROCESSING SYSTEM**

(30) Priority: 08.11.2022 JP 2022178903
(71) Applicant: Tokyo Electron Limited, Tokyo 107-6325 (JP)
(72) Inventor: ONO, Kenta, Kurokawa-gun, Miyagi 981-3629 (JP); NAKANE, Yuta, Kurokawa-gun, Miyagi 981-3629 (JP); KUMAKURA, Sho, Kurokawa-gun, Miyagi 981-3629 (JP); NISHIZUKA, Tetsuya, Kurokawa-gun, Miyagi 981-3629 (JP); HONDA, Masanobu, Kurokawa-gun, Miyagi 981-3629 (JP)
(74) Representative: FRKelly
(86) International application number: PCT/JP2023/038633
(87) International publication number: WO 2024/101166

(57) **Abstract**

A substrate processing method is provided. The method includes (a) providing a substrate including an underlying film; and (b) forming a metal-containing resist film on the underlying film by using a metal-containing precursor and a polyfunctional compound, the metal-containing precursor having a photosensitive group.

## Description

### Technical Field

An exemplary embodiment of the present disclosure relates to a substrate processing method, a composition for forming a metal-containing resist, a metal-containing resist, and a substrate processing system.

### Background Art

Patent Literature 1 discloses a technique for forming a thin film that may be patterned using extreme ultraviolet light (hereinafter, referred to as "EUV") on a semiconductor substrate.

### Citation List

### Patent Literature

Patent Literature 1: PCT Japanese Translation Patent Publication No. 2021-523403

### Summary of Invention

### Technical Problem

The present disclosure provides a technique for adjusting a composition of a metal-containing resist film formed on a substrate.

### Solution to Problem

In one exemplary embodiment of the present disclosure, there is provided a substrate processing method including: (a) providing a substrate, the substrate including an underlying film; and (b) forming a metal-containing resist film on the underlying film by using a metal-containing precursor and a polyfunctional compound, the metal-containing precursor having a photosensitive group.

### Advantageous Effect of Invention

According to one exemplary embodiment of the present disclosure, it is possible to provide a technique for adjusting a composition of a metal-containing resist film formed on a substrate.

### Brief Description of Drawings

[Figure 1] Figure 1 is a diagram for describing a configuration example of a heating processing system.
[Figure 2] Figure 2 is a diagram for describing a configuration example of a plasma processing system.
[Figure 3] Figure 3 is a diagram for describing a configuration example of a capacitively coupled plasma processing apparatus.
[Figure 4] Figure 4 is a diagram for describing a configuration example of a liquid processing system.
[Figure 5] Figure 5 is a flowchart illustrating the present processing method.
[Figure 6] Figure 6 is a view illustrating an example of an underlying film UF of a substrate W.
[Figure 7] Figure 7 is a view illustrating an example of the underlying film UF of the substrate W.
[Figure 8] Figure 8 is a view illustrating an example of a cross-sectional structure of the substrate W on which a metal-containing resist film RM is formed.
[Figure 9] Figure 9 is a flowchart illustrating an example of step ST2 using an ALD method.
[Figure 10] Figure 10 is a flowchart illustrating an example of step ST2 using an ALD method.
[Figure 11] Figure 11 is a diagram schematically illustrating an example of a phenomenon occurring on a surface of the substrate W in step ST2 using the ALD method.
[Figure 12] Figure 12 is a block diagram for describing a configuration example of a substrate processing system SS.
[Figure 13] Figure 13 is a flowchart illustrating a method MT.

### Description of Embodiments

Hereinafter, each embodiment according to the present disclosure will be described.

In one exemplary embodiment, there is provided a substrate processing method including: (a) providing a substrate including an underlying film; and (b) forming a metal-containing resist film on the underlying film by using a metal-containing precursor and a polyfunctional compound, the metal-containing precursor having a photosensitive group.

In one exemplary embodiment, the metal-containing precursor includes a compound (α) having an amine group and/or an alkoxy group.

In one exemplary embodiment, the compound (α) includes a compound (α1) including at least one metal selected from the group consisting of Sn, Ti, Hf, Zr, and In.

In one exemplary embodiment, the compound (α1) includes Sn.

In one exemplary embodiment, the photosensitive group includes at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3).

In one exemplary embodiment, the polyfunctional compound includes at least one compound (β) selected from the group consisting of a polyalcohol, a polythiol, a polycarboxylic acid, a polyisocyanate, and a polyisothiocyanate.

In one exemplary embodiment, in the (b), at least one selected from the group consisting of H₂O, H₂O₂, O₃, and O₂ is further used.

In one exemplary embodiment, the (b) includes (b1) supplying a gas including the metal-containing precursor to the underlying film to form a metal-containing precursor film, and (b2) supplying a gas including the polyfunctional compound to the metal-containing precursor film to form the metal-containing resist film from the metal-containing precursor film.

In one exemplary embodiment, the (b1) and the (b2) are repeated a plurality of times.

In one exemplary embodiment, the (b) includes forming the metal-containing resist film using a mixed gas including the metal-containing precursor and the polyfunctional compound.

In one exemplary embodiment, the metal-containing precursor includes a metal complex containing at least one metal selected from the group consisting of Sn, Ti, Hf, Zr, and In.

In one exemplary embodiment, the polyfunctional compound includes at least one compound (β) selected from the group consisting of a polyalcohol, a polythiol, a polycarboxylic acid, a polyisocyanate, and a polyisothiocyanate.

In one exemplary embodiment, the (b) includes applying a solution containing the metal-containing precursor and the polyfunctional compound onto the underlying film, and heating the applied solution to form the metal-containing resist film.

In one exemplary embodiment, the substrate processing method further includes (c) exposing, after the (b), the substrate to form an exposed first region and an unexposed second region on the metal-containing resist film; and (d) developing the substrate to selectively remove the second region from the metal-containing resist film.

In one exemplary embodiment, in the (d), the second region is removed with a development gas or a developer containing a weak acid.

In one exemplary embodiment, the weak acid includes an organic acid having a pKa < 16.

In one exemplary embodiment, the organic acid includes at least one selected from the group consisting of an alcohol, a thiol, a carboxylic acid, a sulfonic acid, a β-diketone, an alkyl carbonate, and an azole.

In one exemplary embodiment, there is provided a composition for forming a metal-containing resist, including: a metal-containing precursor having a photosensitive group; and a polyfunctional compound, in which the metal-containing precursor includes a compound having the photosensitive group, an amine group, and/or an alkoxy group.

In one exemplary embodiment, there is provided a metal-containing resist including: a compound having a repeating unit represented by the following Formula (1) in a molecule:

-(M-X-A-X)- (1)

(in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

In one exemplary embodiment, there is provided a substrate processing system including: one or a plurality of substrate processing apparatuses; and a controller, in which the controller is configured to execute, with respect to the one or the plurality of substrate processing apparatuses, (a) providing a substrate including an underlying film, and (b) forming a metal-containing resist film on the underlying film using a metal-containing precursor having a photosensitive group and a polyfunctional compound.

In one exemplary embodiment, there is provided a developing method including: (a) providing a substrate including an underlying film and a metal-containing resist on the underlying film; (b) exposing the metal-containing resist via an exposure mask to form an exposed first region and an unexposed second region on the metal-containing resist; and (c) selectively removing one of the first region and the second region, in which the metal-containing resist in the (a) contains a compound having a repeating unit represented by the following Formula (1) in a molecule:

-(M-X-A-X)- (1)

(in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

In one exemplary embodiment, there is provided an etching method including: (a) providing a substrate including an underlying film and a metal-containing resist on the underlying film, in which the metal-containing resist has at least one opening; and (b) etching the underlying film via the opening, in which the metal-containing resist contains a compound having a repeating unit represented by the following Formula (1) in a molecule:

-(M-X-A-X)- (1)

(in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

Hereinafter, each embodiment of the present disclosure will be described in detail with reference to the drawings. In each drawing, the same or similar elements will be given the same reference numerals, and repeated descriptions will be omitted. Unless otherwise specified, a positional relationship such as up, down, left, and right will be described based on a positional relationship illustrated in the drawings. A dimensional ratio in the drawings does not indicate an actual ratio, and the actual ratio is not limited to the ratio illustrated in the drawings.

The substrate processing method according to the present disclosure may be executed by a substrate processing system. In an embodiment, a substrate processing system includes: one or a plurality of substrate processing apparatuses; and a controller, in which the controller is configured to execute, with respect to the one or the plurality of substrate processing apparatuses, (a) control of providing a substrate including an underlying film and (b) control of forming a metal-containing resist film on the underlying film using a metal-containing precursor having a photosensitive group and a polyfunctional compound. The substrate processing system according to the present disclosure may include a heating processing system, a plasma processing system, a liquid processing system, and the like.

### <Configuration Example of Heating Processing System>

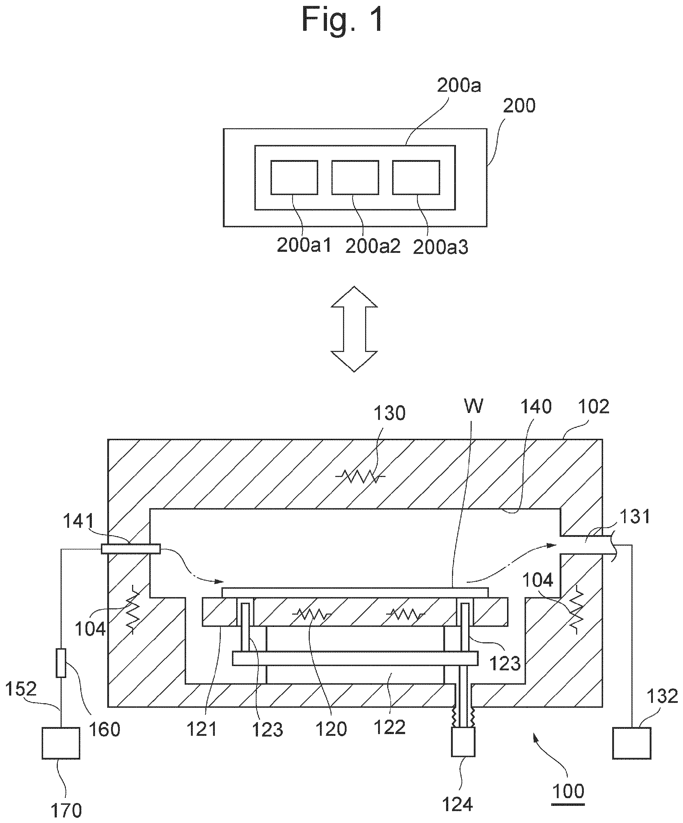

Figure 1 is a diagram for describing a configuration example of a heating processing system. In an embodiment, the heating processing system includes a heating processing apparatus 100 and a controller 200. The heating processing system is an example of a substrate processing system, and the heating processing apparatus 100 is an example of a substrate processing apparatus.

The heating processing apparatus 100 has a processing chamber 102 configured to form a sealed space. The processing chamber 102 is, for example, an airtight cylindrical container, and is configured to be able to adjust the atmosphere inside. A side wall heater 104 is provided on a side wall of the processing chamber 102. A ceiling heater 130 is provided on a ceiling wall (top plate) of the processing chamber 102. A ceiling surface 140 of the ceiling wall (top plate) of the processing chamber 102 is formed as a horizontal flat surface, and a temperature thereof is adjusted by the ceiling heater 130.

A substrate support 121 is provided on a lower side in the processing chamber 102. The substrate support 121 has a substrate support surface on which a substrate W is supported. The substrate support 121 is formed, for example, in a circular shape in a plan view, and the substrate W is placed on a surface (upper surface) thereof that is formed horizontally. A stage heater 120 is embedded in the substrate support 121. The stage heater 120 is able to heat the substrate W placed on the substrate support 121. A ring assembly (not illustrated) may be disposed on the substrate support 121 to surround the substrate W. The ring assembly may include one or a plurality of annular members. By disposing the ring assembly around the substrate W, it is possible to improve the temperature controllability of an outer peripheral region of the substrate W. The ring assembly may be made of an inorganic material or an organic material depending on desired heating processing.

The substrate support 121 is supported in the processing chamber 102 by a support column 122 provided on a bottom surface of the processing chamber 102. A plurality of lifting and lowering pins 123 that is able to be vertically lifted or lowered is provided on an outside of the support column 122 in a circumferential direction. Each of the plurality of lifting and lowering pins 123 is inserted into each of through-holes provided in the substrate support 121. The plurality of lifting and lowering pins 123 is arranged at intervals in the circumferential direction. Lifting and lowering operations of the plurality of lifting and lowering pins 123 are controlled by a lifting and lowering mechanism 124. When the lifting and lowering pin 123 protrudes from the surface of the substrate support 121, the substrate W is able to be delivered between a transport mechanism (not illustrated) and the substrate support 121.

An exhaust port 131 having an opening is provided in a side wall of the processing chamber 102. The exhaust port 131 is connected to an exhaust mechanism 132 via an exhaust pipe. The exhaust mechanism 132 is configured of a vacuum pump, a valve, and the like, and adjusts an exhaust flow rate from the exhaust port 131. A pressure in the processing chamber 102 is adjusted by adjusting the exhaust flow rate and the like by the exhaust mechanism 132. A transport port (not illustrated) of the substrate W is formed on the side wall of the processing chamber 102 to be openable and closable at a position different from a position at which the exhaust port 131 is opened.

In addition, a gas nozzle 141 is provided on the side wall of the processing chamber 102 at a position different from the positions of the exhaust port 131 and the transport port of the substrate W. The gas nozzle 141 supplies a processing gas into the processing chamber 102. The gas nozzle 141 is provided on a side opposite to the exhaust port 131 as viewed from a center portion of the substrate support 121 in the side wall of the processing chamber 102. That is, the gas nozzle 141 is provided to be symmetrical with respect to the exhaust port 131 on a vertical imaginary plane passing through the center portion of the substrate support 121 in the side wall of the processing chamber 102.

The gas nozzle 141 is formed in a rod shape that protrudes from the side wall of the processing chamber 102 toward the center side of the processing chamber 102. A distal end portion of the gas nozzle 141 extends, for example, horizontally from the side wall of the processing chamber 102. The processing gas is discharged into the processing chamber 102 from a discharge port that is open at the distal end of the gas nozzle 141, flows in a direction of a one-dot chain line arrow illustrated in Figure 1, and is exhausted from the exhaust port 131. The distal end portion of the gas nozzle 41 may have a shape that extends obliquely downward toward the substrate W, or may have a shape that extends obliquely upward toward the ceiling surface 140 of the processing chamber 102.

The gas nozzle 141 may be provided, for example, on the ceiling wall of the processing chamber 102. In addition, the exhaust port 131 may be provided on the bottom surface of the processing chamber 102.

The heating processing apparatus 100 includes a gas supply pipe 152 connected to the gas nozzle 141 from the outside of the processing chamber 102. A pipe heater 160 for heating the gas in the gas supply pipe is provided around the periphery of the gas supply pipe 152. The gas supply pipe 152 is connected to a gas supply 170. The gas supply 170 includes at least one gas source and at least one flow rate controller. The gas supply may include a vaporizer that vaporizes a material in a liquid state.

The controller 200 processes a computer-executable instruction that causes the heating processing apparatus 100 to execute various steps described in the present disclosure. The controller 200 may be configured to control each element of the heating processing apparatus 100 to execute the various steps described here. In an embodiment, a part or all of the controller 200 may be included in the heating processing apparatus 100. The controller 200 may include a processor 200a1, a storage unit 200a2, and a communication interface 200a3. The controller 200 is realized by, for example, a computer 200a. The processor 200a1 may be configured to read out a program from the storage unit 200a2 and execute the read out program to perform various control operations. This program may be stored in the storage unit 200a2 in advance, or may be acquired through a medium when necessary. The acquired program is stored in the storage unit 200a2 and is read out from the storage unit 200a2 and executed by the processor 200a1. The medium may be various storage media readable by the computer 200a, or may be a communication line connected to the communication interface 200a3. The processor 200a1 may be a central processing unit (CPU). The storage unit 200a2 may include a random access memory (RAM), a read only memory (ROM), a hard disk drive (HDD), a solid state drive (SSD), or a combination thereof. The communication interface 200a3 may communicate with the heating processing apparatus 100 through a communication line such as a local area network (LAN).

### <Configuration Example of Plasma Processing System>

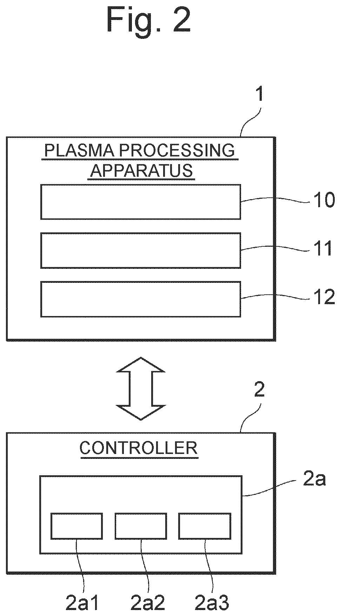

Figure 2 is a diagram for describing a configuration example of the plasma processing system. In an embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas to the plasma processing space and at least one gas exhaust port for exhausting the gas from the plasma processing space. The gas supply port is connected to a gas supply 20, described later, and the gas exhaust port is connected to an exhaust system 40, described later. The substrate support 11 is disposed in the plasma processing space and has a substrate support surface for supporting a substrate.

The plasma generator 12 is configured to form a plasma from at least one processing gas supplied into the plasma processing space. The plasma formed in the plasma processing space may be a capacitively coupled plasma (CCP), an inductively coupled plasma (ICP), an electron-cyclotron-resonance plasma (ECR), a helicon wave plasma (HWP), a surface wave plasma (SWP), or the like. Further, various types of plasma generators including an alternating current (AC) plasma generator and a direct current (DC) plasma generator may be used. In an embodiment, an AC signal (AC power) used in the AC plasma generator has a frequency in the range of 100 kHz to 10 GHz. Therefore, the AC signal includes a radio frequency (RF) signal and a microwave signal. In an embodiment, an RF signal has a frequency in the range of 100 kHz to 150 MHz.

The controller 2 processes a computer-executable instruction that causes the plasma processing apparatus 1 to execute various steps described in the present disclosure. The controller 2 may be configured to control each element of the plasma processing apparatus 1 to execute the various steps described here. In an embodiment, a part or all of the controller 2 may be included in the plasma processing apparatus 1. The controller 2 is realized by, for example, a computer 2a. The controller 2 may include a processor 2a1, a storage unit 2a2, and a communication interface 2a3. Each configuration of the controller 2 may be the same as each configuration of the above-described controller 200 (see Figure 1).

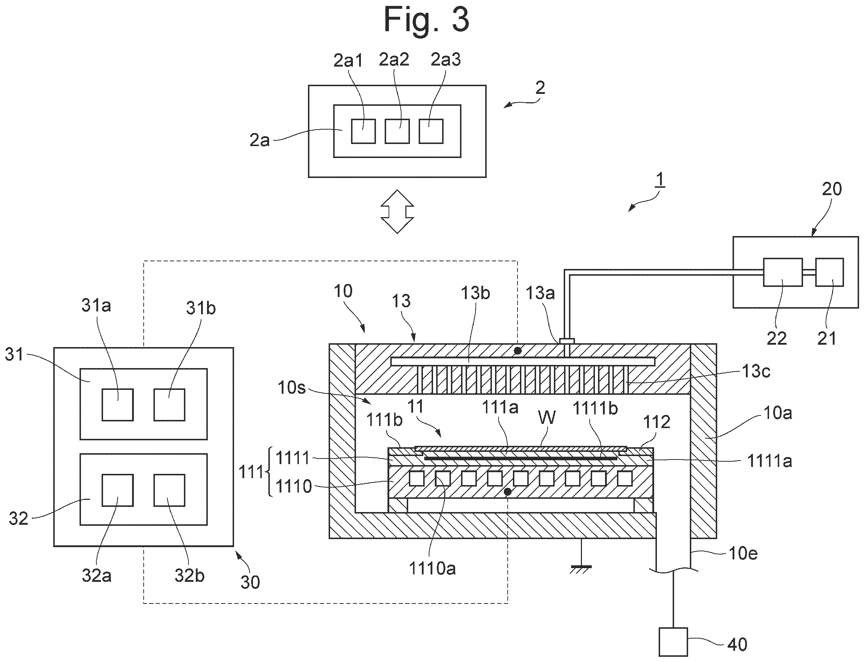

Hereinafter, a configuration example of the capacitively coupled plasma processing apparatus as an example of the plasma processing apparatus 1 will be described. Figure 3 is a diagram for describing the configuration example of the capacitively coupled plasma processing apparatus.

The capacitively coupled plasma processing apparatus 1 includes the plasma processing chamber 10, the gas supply 20, a power supply 30, and the exhaust system 40. In addition, the plasma processing apparatus 1 includes the substrate support 11 and a gas introducer. The gas introducer is configured to introduce at least one processing gas into the plasma processing chamber 10. The gas introducer includes a shower head 13. The substrate support 11 is disposed in the plasma processing chamber 10. The shower head 13 is disposed above the substrate support 11. In an embodiment, the shower head 13 configures at least a part of a ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a main body 111 and a ring assembly 112. The main body 111 has a center region 111a for supporting the substrate W and an annular region 111b for supporting the ring assembly 112. A wafer is an example of the substrate W. The annular region 111b of the main body 111 surrounds the center region 111a of the main body 111 in plan view. The substrate W is disposed on the center region 111a of the main body 111, and the ring assembly 112 is disposed on the annular region 111b of the main body 111 to surround the substrate W on the center region 111a of the main body 111. Therefore, the center region 111a is also referred to as a substrate support surface for supporting the substrate W, and the annular region 111b is also referred to as a ring support surface for supporting the ring assembly 112.

In an embodiment, the main body 111 includes a base 1110 and an electrostatic chuck 1111. The base 1110 includes a conductive member. The conductive member of the base 1110 may function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the center region 111a. In an embodiment, the ceramic member 1111a also has the annular region 111b. Another member that surrounds the electrostatic chuck 1111 may have the annular region 111b, such as an annular electrostatic chuck or an annular insulating member. In this case, the ring assembly 112 may be disposed on the annular electrostatic chuck or the annular insulating member, or may be disposed on both the electrostatic chuck 1111 and the annular insulating member. Further, at least one RF/DC electrode coupled to a RF power supply 31 and/or a DC power supply 32, which will be described later, may be disposed in the ceramic member 1111a. In this case, at least one RF/DC electrode functions as the lower electrode. When a bias RF signal and/or a DC signal, which will be described later, are supplied to at least one RF/DC electrode, the RF/DC electrode is also referred to as a bias electrode. The conductive member of the base 1110 and at least one RF/DC electrode may function as a plurality of lower electrodes. Further, the electrostatic electrode 1111b may function as the lower electrode. Therefore, the substrate support 11 includes at least one lower electrode.

The ring assembly 112 includes one or a plurality of annular members. In an embodiment, one or the plurality of annular members includes one or a plurality of edge rings and at least one cover ring. The edge ring is formed of a conductive material or an insulating material, and the cover ring is formed of an insulating material.

In addition, the substrate support 11 may include a temperature-controlled module configured to adjust at least one of the electrostatic chuck 1111, the ring assembly 112, and the substrate to a target temperature. The temperature-controlled module may include a heater, a heat transfer medium, a flow passage 1110a, or a combination thereof. A heat transfer fluid such as brine or a gas flows in the flow passage 1110a. In an embodiment, the flow passage 1110a is formed in the base 1110, and one or a plurality of heaters is disposed in the ceramic member 1111a of the electrostatic chuck 1111. Further, the substrate support 11 may include a heat transfer gas supply configured to supply the heat transfer gas to a gap between a back surface of the substrate W and the center region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. In addition to the shower head 13, the gas introducer may include one or a plurality of side gas injectors (SGI) attached to one or a plurality of opening portions formed on the side wall 10a.

The gas supply 20 may include at least one gas source 21 and at least one flow rate controller 22. In an embodiment, the gas supply 20 is configured to supply at least one processing gas to the shower head 13 from each corresponding gas source 21 through each corresponding flow rate controller 22. Each flow rate controller 22 may include, for example, a mass flow controller or a pressure-controlled flow rate controller. Further, the gas supply 20 may include at least one flow rate modulation device that modulates or pulses a flow rate of at least one processing gas.

The power supply 30 includes the RF power supply 31 coupled to the plasma processing chamber 10 via at least one impedance matching circuit. The RF power supply 31 is configured to supply at least one RF signal (RF power) to at least one lower electrode and/or at least one upper electrode. As a result, plasma is formed from at least one processing gas supplied to the plasma processing space 10s. Therefore, the RF power supply 31 may function as at least a part of the plasma generator 12. Further, by supplying the bias RF signal to at least one lower electrode, a bias potential is generated in the substrate W, and an ion component in the formed plasma can be drawn into the substrate W.

In an embodiment, the RF power supply 31 includes a first RF generator 31a and a second RF generator 31b. The first RF generator 31a is coupled to at least one lower electrode and/or at least one upper electrode via at least one impedance matching circuit and is configured to generate a source RF signal (source RF power) for plasma formation. In an embodiment, the source RF signal has a frequency in a range of 10 MHz to 150 MHz. In an embodiment, the first RF generator 31a may be configured to generate a plurality of source RF signals having different frequencies. The generated one or plurality of source RF signals is supplied to at least one lower electrode and/or at least one upper electrode.

The second RF generator 31b is coupled to at least one lower electrode via at least one impedance matching circuit and is configured to generate the bias RF signal (bias RF power). The frequency of the bias RF signal may be the same as or different from the frequency of the source RF signal. In an embodiment, the bias RF signal has a frequency lower than the frequency of the source RF signal. In an embodiment, the bias RF signal has a frequency in a range of 100 kHz to 60 MHz. In an embodiment, the second RF generator 31b may be configured to generate a plurality of bias RF signals having different frequencies. The generated one or plurality of bias RF signals is supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In an embodiment, the first DC generator 32a is connected to at least one lower electrode, and is configured to generate the first DC signal. The generated first DC signal is applied to at least one lower electrode. In an embodiment, the second DC generator 32b is connected to at least one upper electrode and is configured to generate a second DC signal. The generated second DC signal is applied to at least one upper electrode.

In various embodiments, the first and second DC signals may be pulsed. In this case, a sequence of voltage pulses is applied to at least one lower electrode and/or at least one upper electrode. The voltage pulse may have a pulse waveform having a rectangular shape, a trapezoidal shape, a triangular shape, or a combination thereof. In an embodiment, a waveform generator for generating the sequence of voltage pulses from the DC signal is connected between the first DC generator 32a and at least one lower electrode. Therefore, the first DC generator 32a and the waveform generator configure the voltage pulse generator. When the second DC generator 32b and the waveform generator configure the voltage pulse generator, the voltage pulse generator is connected to at least one upper electrode. The voltage pulse may have a positive polarity or a negative polarity. In addition, the sequence of voltage pulses may include one or a plurality of positive voltage pulses and one or a plurality of negative voltage pulses in one cycle. The first and second DC generators 32a and 32b may be provided in addition to the RF power supply 31, or the first DC generator 32a may be provided instead of the second RF generator 31b.

The exhaust system 40 may be connected to, for example, a gas exhaust port 10e provided at a bottom portion of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

### <Configuration Example of Liquid Processing System>

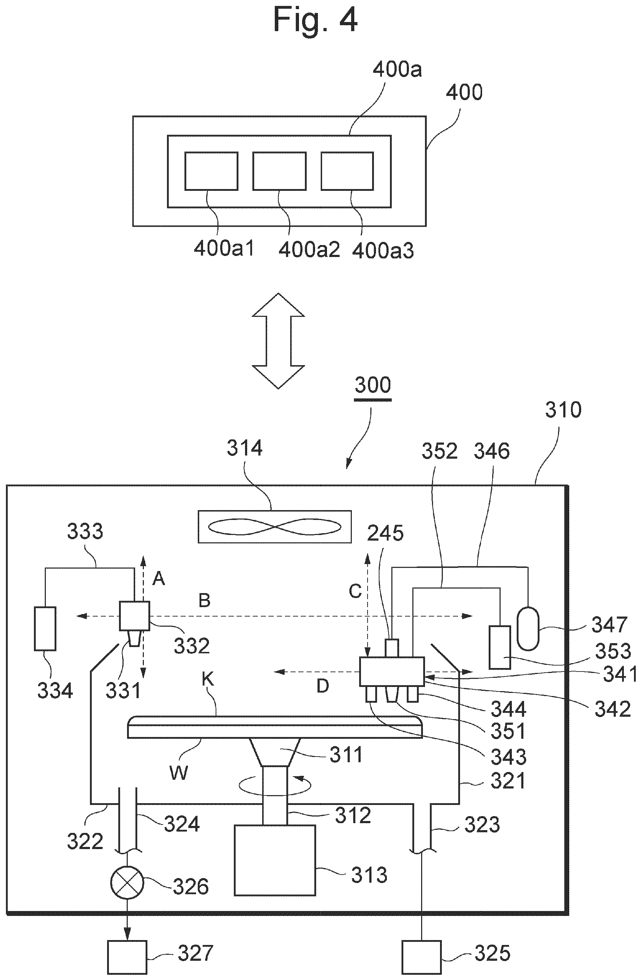

Figure 4 is a diagram for describing a configuration example of a liquid processing system. In an embodiment, the liquid processing system includes a liquid processing apparatus 300 and a controller 400. The liquid processing system is an example of a substrate processing system, and the liquid processing apparatus 300 is an example of a substrate processing apparatus.

As illustrated in Figure 4, the liquid processing apparatus 300 has a spin chuck 311 as a substrate support in a processing chamber 310. The spin chuck 311 holds the substrate W horizontally. The spin chuck 311 is connected to a liftable and lowerable rotating portion 312, and the rotating portion 312 is connected to a rotational drive unit 313 configured by a motor or the like. The substrate W held by the spin chuck 311 is able to be rotated by the driving of the rotational drive unit 313.

A cup 321 is disposed outside the spin chuck 311, and scattering of a processing liquid (a resist solution, a developer, a cleaning liquid, or the like) or a mist of the processing liquid to the periphery of the cup 321 is prevented. A waste liquid pipe 323 and an exhaust pipe 324 are provided at a bottom portion 322 of the cup 321. The waste liquid pipe 323 communicates with a waste liquid apparatus 325 such as a waste liquid pump. The exhaust pipe 324 communicates with an exhaust apparatus 327 such as an exhaust pump via a valve 326.

A blower apparatus 314 that supplies air having a required temperature and humidity to the inside of the cup 321 as downflow is provided above the processing chamber 310 of the liquid processing apparatus 300.

When forming a puddle of the processing liquid on the substrate W, a processing liquid supply nozzle 331 is used. The processing liquid supply nozzle 331 is provided on, for example, a nozzle support 332 such as an arm, and the nozzle support 332 is liftable and lowerable by a drive mechanism as illustrated by a reciprocating arrow A indicated by a broken line in the drawing, and is movable horizontally as illustrated by a reciprocating arrow B indicated by a broken line in the drawing. A processing liquid (resist solution, developer, or the like) is supplied from a processing liquid source 334 to the processing liquid supply nozzle 331 via a supply pipe 333.

In a case where a so-called long nozzle including a discharge port having a length equal to or greater than a diameter of the substrate W is used in forming the puddle, the puddle of the processing liquid is able to be formed on the substrate W by scanning the substrate W from one end portion to the other end portion. In addition, in a case of a so-called straight type nozzle that discharges a liquid to form a liquid column having a sufficiently small width compared to the diameter of the substrate W, the entire surface of the substrate W is able to be diffused with the processing liquid and a puddle of the processing liquid is able to be formed on the substrate W by positioning the discharge port above the center of the substrate W and discharging the processing liquid while rotating the substrate W. In addition, the formation of the puddle of the processing liquid may be performed by scanning the substrate W with a straight type nozzle in the same manner as the long nozzle, or by arranging a plurality of discharge ports that discharges a liquid, such as the straight type, on the substrate W and supplying the processing liquid from each of the discharge ports.

A gas nozzle 341 has a nozzle body 342. The nozzle body 342 is provided at the nozzle support such as an arm, and the nozzle support is liftable and lowerable by a drive mechanism as illustrated by a reciprocating arrow C indicated by a broken line, and is movable horizontally as illustrated by a reciprocating arrow D indicated by a broken line in the drawing.

The gas nozzle 341 has two nozzle discharge ports 343 and 344. The nozzle discharge ports 343 and 344 are formed by being branched from a gas flow passage 345. The gas flow passage 345 communicates with a gas source 347 via a gas supply pipe 346. As the inert gas or the non-oxidizing gas, for example, nitrogen gas is prepared in the gas source 347. For example, when nitrogen gas is supplied from the gas flow passage 345 to the gas nozzle 341, the nitrogen gas is discharged from the respective nozzle discharge ports 343 and 344.

In addition, the gas nozzle 341 is provided with a cleaning liquid supply nozzle 351 for cleaning the processing liquid after the liquid processing from the substrate W. The cleaning liquid supply nozzle 351 communicates with a cleaning liquid source 353 via a cleaning liquid supply pipe 352. As the cleaning liquid, for example, pure water is used. The cleaning liquid supply nozzle 351 is positioned between the two nozzle discharge ports 343 and 344 described above, but the position thereof is not limited thereto. The cleaning liquid supply nozzle 351 may be configured independently of the gas nozzle 341.

The controller 400 processes a computer-executable instruction that causes the liquid processing apparatus 300 to execute various steps described in the present disclosure. The controller 400 may be configured to control each element of the liquid processing apparatus 300 to execute the various steps described here. In an embodiment, a part or all of the controller 400 may be included in the liquid processing apparatus 300. The controller 400 is realized by, for example, a computer 400a. The computer 400a may include a processor 400a1, a storage unit 400a2, and a communication interface 400a3. Each configuration of the controller 400 may be the same as each configuration of the controller 200 (see Figure 1) described above.

### <Example of Substrate Processing Method>

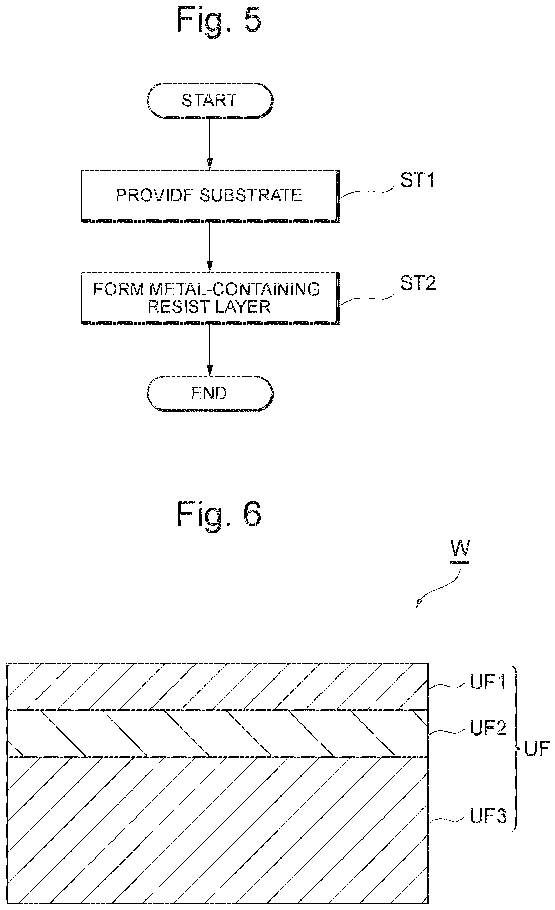

Figure 5 is a flowchart illustrating a substrate processing method (hereinafter, also referred to as "the present processing method") according to an exemplary embodiment. The present processing method includes step ST1 of providing a substrate including an underlying film and step ST2 of forming a metal-containing resist film on the underlying film. In an embodiment, the processing for forming the metal-containing resist film in step ST2 (hereinafter, also referred to as a "film forming processing") is performed by a dry process using a processing gas (hereinafter, also referred to as "dry film formation"). In an embodiment, the film forming processing in step ST2 is performed by the wet process (hereinafter, also referred to as "wet film formation") using a solution. In an embodiment, the film forming processing in step ST2 is performed using both wet film formation and dry film formation.

The present processing method can include (a) a step of providing the substrate including the underlying film (corresponding to "step ST1" described later) and (b) a step of forming the metal-containing resist film on the underlying film by using a metal-containing precursor having a photosensitive group and a polyfunctional compound (corresponding to "step ST2" described later). Each step may be executed by using any one of the above-described substrate processing systems (see Figures 1 to 4), or may be executed by using two or more of these substrate processing systems. For example, the present processing method may be executed by the heating processing system (see Figure 1). In the following, a case where the controller 200 controls each unit of the heating processing apparatus 100 to execute the present processing method on the substrate W will be described as an example.

### (Step ST1: Provision of Substrate)

First, in step ST1, the substrate W is provided in the processing chamber 102 of the heating processing apparatus 100. The substrate W is provided on the substrate support 121 via the lifting and lowering pin 123. After the substrate W is disposed on the substrate support 121, the temperature of the substrate support 121 is adjusted to a set temperature. The set temperature may be, for example, a temperature of 350°C or lower, and may be a temperature of 25°C or higher and 350°C or lower. The temperature adjustment of the substrate support 121 may be performed by controlling an output of one or more heaters of the side wall heater 104, the stage heater 120, the ceiling heater 130, and the pipe heater 160 (hereinafter, also referred to as "each heater"). In the present processing method, the temperature of the substrate support 121 may be adjusted to the set temperature before step ST1. That is, the substrate W may be provided in the substrate support 121 after the temperature of the substrate support 121 is adjusted to the set temperature.

The substrate W may be used for manufacturing a semiconductor device. The semiconductor device includes, for example, a semiconductor memory device such as a DRAM or a 3D-NAND flash memory, and a logic device. The substrate W has the underlying film UF. The underlying film UF may be an organic film, a dielectric film, a metal film, or a semiconductor film, or a film stack thereof formed on a silicon wafer. In an embodiment, the underlying film UF includes, for example, at least one selected from the group consisting of a silicon-containing film, a carbon-containing film, and a metal-containing film.

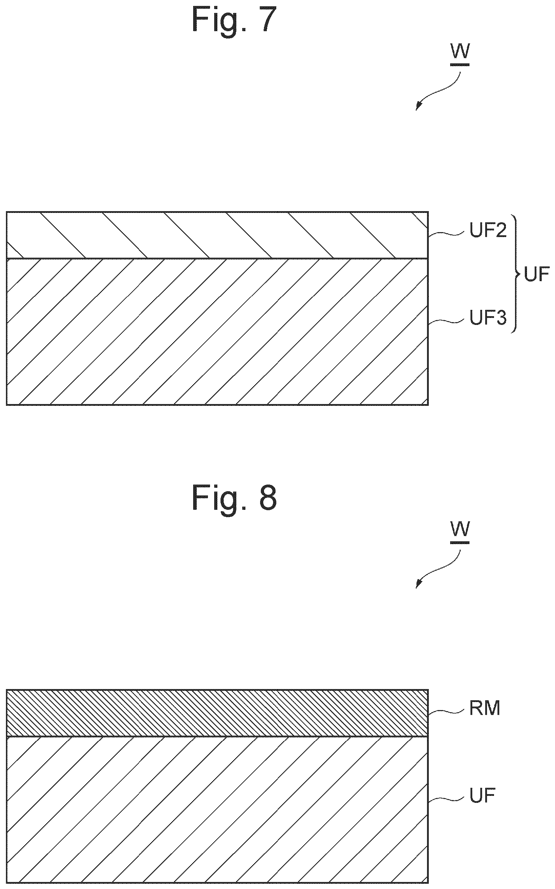

Figures 6 and 7 are views illustrating an example of the underlying film UF of the substrate W, respectively. As illustrated in Figure 6, the underlying film UF may be configured of a first film UF1, a second film UF2, and a third film UF3. As illustrated in Figure 7, the underlying film UF may be configured of the second film UF2 and the third film UF3. In an embodiment, the underlying film UF may be subjected to surface reforming processing.

The first film UF1 is, for example, a spin-on glass (SOG) film, a SiC film, a SiON film, a Si-containing antireflection film (SiARC), or an organic film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon acid nitride film, a silicon carbon nitride film, a polycrystalline silicon film, or a carbon-containing silicon film. The third film UF3 may be configured of a plurality of types of stacked silicon-containing films. For example, the third film UF3 may be configured of a silicon oxide film and a silicon nitride film which are alternately stacked. In addition, the third film UF3 may be configured of a silicon oxide film and a polycrystalline silicon film which are stacked. In addition, the third film UF3 may be a film stack including a silicon nitride film, a silicon oxide film, and a polycrystalline silicon film. In addition, the third film UF3 may be configured of a stacked silicon oxide film and silicon carbon nitride film. In addition, the third film UF3 may be a film stack including a silicon oxide film, a silicon nitride film, and a silicon carbon nitride film.

A part or all of the underlying film UF may be formed in the processing chamber 102 of the heating processing apparatus 100, or may be formed by using another system, for example, a plasma processing system (see Figures 2 and 3) or a liquid processing system (see Figure 4).

### (Step ST2: Formation of Metal-containing Resist Film)

Next, in step ST2, the metal-containing resist film RM is formed on the underlying film UF of the substrate W. In step ST2, a metal-containing precursor having a photosensitive group and a polyfunctional compound can be used to form the metal-containing resist film RM on the underlying film UF. The photosensitive group means a group that may be eliminated by exposure due to the photosensitivity of adjacent metal atoms. Examples of the photosensitive group include a hydrogen atom, a hydrocarbon group g1 which may be substituted with a halogen, and the like. Examples of the hydrocarbon group g1 which may be substituted include a linear or branched alkyl group such as a methyl group, an ethyl group, an n-propyl group, an n-butyl group, an i-propyl group, and a t-butyl group, a halogen-substituted alkyl group such as -CHₓF_{y} (where, x represents an integer of 0 to 2, and y represents an integer of 1 to 3), and the like.

Figure 8 is a diagram illustrating an example of a cross-sectional structure of the substrate W on which the metal-containing resist film RM is formed in step ST2. As illustrated in Figure 8, the metal-containing resist film RM is formed on the surface of the underlying film UF. The metal-containing resist film RM is a film containing a metal. In an exemplary embodiment, the metal-containing resist film RM includes at least one metal selected from the group consisting of Sn, Ti, Hf, Zr, and In. In an example, the metal-containing resist film RM may contain Sn.

In an embodiment, the metal-containing resist film RM contains a compound having a repeating unit represented by the following Formula (1) in a molecule.

-(M-X-A-X)- (1)

(in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

In an example, the divalent group derived from the terminal of the polyalcohol includes an alkoxy bond. In an example, the divalent group derived from the terminal of the polythiol includes a sulfide bond. In an example, the divalent group derived from the terminal of the polycarboxylic acid includes an ester bond. In an example, the divalent group derived from the terminal of the polyisocyanate includes a urethane bond. In an example, the divalent group derived from the terminal of the polyisothiocyanate includes a thiourethane bond. Examples of the divalent organic group which may be provided by A in Formula (1) include a hydrocarbon group g2 which has 2 or more and 10 or less carbon atoms and may be substituted. Examples of the hydrocarbon group g2 which may be substituted include a linear, branched, or cyclic divalent hydrocarbon group. Examples of the linear, branched, or cyclic divalent hydrocarbon group may include a linear, branched, or cyclic alkylene group or arylene group. In the linear, branched, or cyclic alkylene group or arylene group, at least one hydrogen atom in the molecule may be substituted with a halogen or the like.

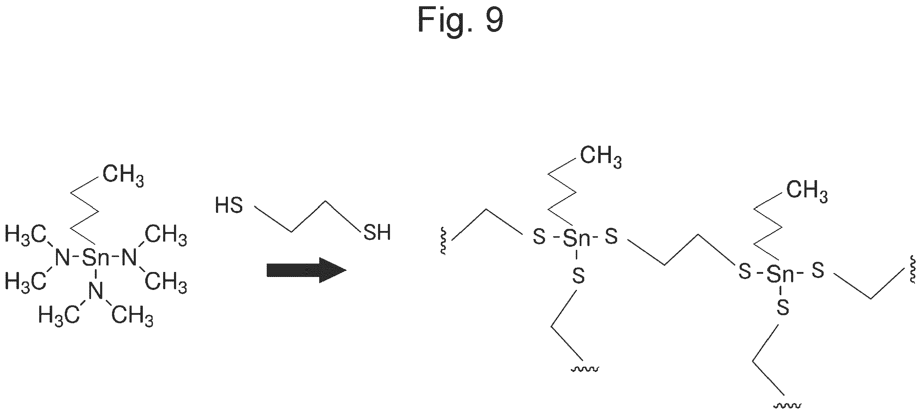

In an example, the repeating unit represented by Formula (1) may be M = Sn, X = -S-, and A = an ethylene group, and an exemplary process for obtaining a compound having such a repeating unit is illustrated in Figure 9. In the example of Figure 9, the metal-containing precursor having a photosensitive group is n-butyltris(dimethylamino)tin, and the polyfunctional compound is ethanedithiol. That is, in the example of Figure 9, a compound having a repeating unit represented by - (Sn-S-CH₂CH₂-S)- is obtained by reacting n-butyltris(dimethylamino)tin with ethanedithiol.

In an embodiment, step ST2 can be carried out by the dry film formation. In the dry film formation, for example:
in an embodiment, the metal-containing precursor can include a compound (α) having an amine group and/or an alkoxy group;
in an embodiment, the compound (α) can include a compound (α1) including at least one metal selected from the group consisting of Sn, Ti, Hf, Zr, and In;
in an embodiment, the compound (α1) can contain Sn;
in an embodiment, the photosensitive group in the metal-containing precursor can include at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3);
in an embodiment, the polyfunctional compound can include at least one compound (β) selected from the group consisting of a polyalcohol, a polythiol, a polycarboxylic acid, a polyisocyanate, and a polyisothiocyanate;
in an embodiment, in the step (b), at least one selected from the group consisting of H₂O, H₂O₂, O₃, and O₂ can be further used.

In the dry film formation, the formation of the metal-containing resist film RM in step ST2 may be carried out by various methods such as an atomic layer deposition (hereinafter, refers to as an "ALD method") method, a CVD method, and the like. Hereinafter, various methods of forming the metal-containing resist film RM will be described.

### (ALD Method)

In an embodiment, in the ALD method, a predetermined material is self-controllably adsorbed and reacted with the underlying film UF of the substrate W to form the metal-containing resist film RM. In an embodiment, the step (b) includes (b1) a step of supplying a gas including a metal-containing precursor to the underlying film to form the metal-containing precursor film, and (b2) a step of supplying a gas including the polyfunctional compound to the metal-containing precursor film to form the metal-containing resist film from the metal-containing precursor film. In an embodiment, the steps of (b1) and (b2) can be repeated a plurality of times.

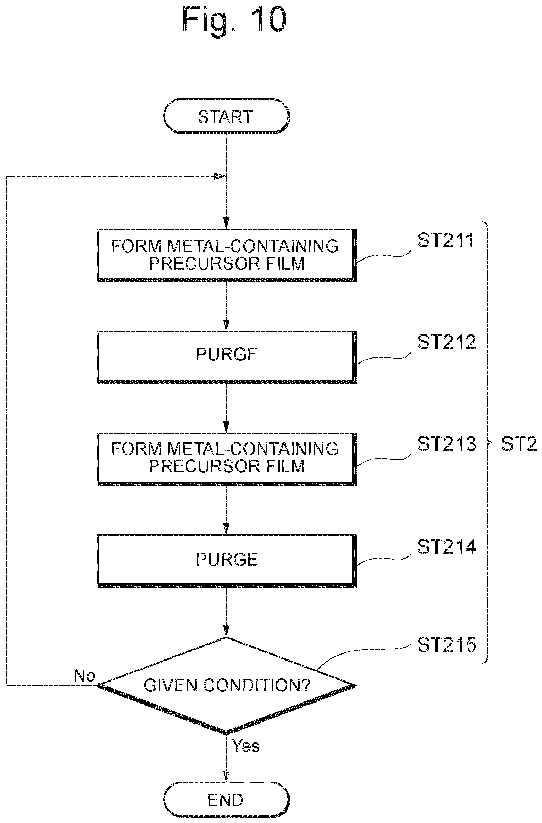

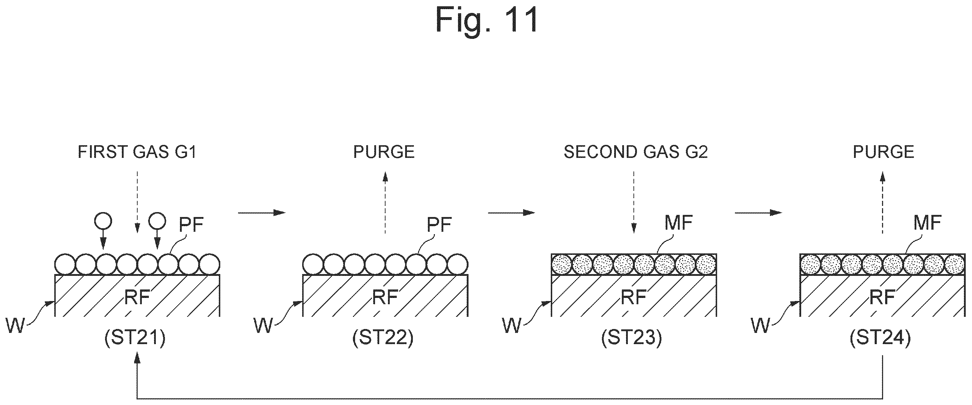

Figure 10 is a flowchart illustrating an example of step ST2 using the ALD method. As illustrated in Figure 10, step ST2 using the ALD method includes step ST211 of forming the metal-containing precursor film, first purge step ST212, step ST213 of forming the metal-containing film from the metal-containing precursor film, second purge step ST214, and determination step ST215. The first purge step ST212 and the second purge step ST214 may or may not be performed. Figure 11 is a diagram schematically illustrating an example of a phenomenon occurring on the surface of the substrate W in step ST21 using the ALD method.

In step ST211, as illustrated in Figure 11, a first gas G1 containing the metal-containing precursor is supplied to the surface of the underlying film UF, and the metal-containing precursor film PF is formed. In an embodiment, the metal-containing precursor includes the compound (α) having an amine group and/or an alkoxy group. The amine group is a monovalent group represented by -NRₐR_{b}, where Rₐ and R_{b} each independently represent an alkyl group having 1 to 2 carbon atoms. Examples of the amine group include a dimethylamino group, a diethylamino group, an ethylmethylamino group, and the like. Examples of the alkoxy group include a methoxy group, an ethoxy group, an n-propoxy group, an n-butoxy group, an i-propoxy group, a t-butoxy group, and the like. In an embodiment, the compound (α) can include a compound (α1) including at least one metal selected from the group consisting of Sn, Ti, Hf, Zr, and In. In an embodiment, the compound (α1) can contain Sn. In an embodiment, the photosensitive group in the metal-containing precursor can include at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3). For example, the metal-containing precursor contains at least one compound selected from the group consisting of an aminotin compound, an aminotitanium compound, an aminohafnium compound, an aminozirconium compound, and an aminoindium compound. Examples of the aminotin compound may include n-butyltris(dimethylamino)tin, t-butyltris(dimethylamino)tin, bis(dimethylamino)dimethyltin, bis(dimethyl)dibutyltin, azidotrimethyltin, bis(dimethylamino)dibutyltin, and the like. Examples of the alkoxytin compound may include dimethyltin bis(tert-butoxide) and bis(dimethoxy)dimethyltin. Examples of the aminotitanium compound, the aminohafnium compound, and the aminozirconium compound may include a compound represented by a compositional formula of MRₓL_{y} (in the formula, M is Ti, Hf, or Zr, R is a photosensitive group, L is an amine group or an alkoxy group which may react with a polyfunctional compound, and x and y satisfy x ≥ 1 and y = 4 - x), and the like. Examples of the aminoindium compound may include a compound represented by a compositional formula of InRₓL_{y} (in the formula, R is a photosensitive group, L is an amine group or an alkoxy group which may react with a polyfunctional compound, and x and y satisfy x ≥ 1 and y = 3 - x), and the like. In an embodiment, the photosensitive group in the metal-containing precursor can include at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3).

In step ST211 in an embodiment, the first gas G1 is supplied into the processing chamber 102 via the gas nozzle 141. Then, in the processing chamber 102, the metal-containing precursor of the first gas G1 is adsorbed on the surface of the underlying film UF, and the metal-containing precursor film PF is formed. The metal-containing precursor film PF may contain, for example, Sn, Ti, Hf, Zr, In, and the like. The metal-containing precursor film PF may be a metal complex. Examples of the metal complex may include aminotin.

In step ST212, the gas in the processing chamber 102 is discharged from the exhaust port 131 by the exhaust mechanism 132. In this case, an inert gas or the like may be supplied to the substrate W. As a result, gases such as an excessive metal-containing precursor are purged. The inert gas is noble gas such as He, Ar, Ne, Kr, and Xe, or nitrogen gas, for example.

In step ST213, as illustrated in Figure 11, the second gas G2 containing the polyfunctional compound is supplied to the surface of the substrate W, and the second gas G2 reacts with the metal-containing precursor film PF to form the metal-containing resist film from the metal-containing precursor film PF. The second gas G2 is a gas that reacts with the metal-containing precursor adsorbed on the surface of the underlying film UF. Water and hydrogen peroxide are not included in the polyfunctional compound. In an embodiment, a compound having divalent or more (2 or more functional groups) may be used as the polyfunctional compound. In an embodiment, the polyfunctional compound may be divalent or trivalent or more. In an embodiment, the polyfunctional compound may include at least one compound (β) selected from the group consisting of a polyalcohol, a polythiol, a polycarboxylic acid, a polyisocyanate, and a polyisothiocyanate. Examples of the polyalcohol may include ethylene glycol, glycerin, and the like. Examples of the polythiol may include ethanedithiol, toluenedithiol, and the like. Examples of the polycarboxylic acid include glutaric acid, adipic acid, terephthalic acid (solution), and the like. Examples of the polyisocyanate may include toluene diisocyanate, and the like. Examples of the polyisothiocyanate may include butanediisothiocyanate, phenylene bis(isothiocyanate), and the like. In Step ST213 in an embodiment, the second gas G2 is supplied into the processing chamber 102 via the gas nozzle 141. In an embodiment, the second gas G2 may include at least one selected from the group consisting of an H₂O gas, H₂O₂, O₃, and O₂. In an embodiment, at least one selected from the group consisting of H₂O gas, H₂O₂, O₃, and O₂ is supplied into the processing chamber 102 as a gas different from the second gas G2. Then, the second gas G2 and the metal-containing precursor film PF react with each other in the processing chamber 102 to form the metal-containing resist film.

In step ST214, the gas in the processing chamber 102 is discharged from the exhaust port 131 by the exhaust mechanism 132. In this case, an inert gas or the like may be supplied to the substrate W. As a result, excessive gas such as the second gas G2 is purged.

In step ST215, it is determined whether a given condition for ending step ST21 is satisfied. The given condition may be that the processing from step ST211 to step ST214 is performed a number of times set in advance, as one cycle. The number of times may be once, less than 5 times, 5 times or more, or 10 times or more. In a case where it is determined that the given condition is not satisfied in step ST215, the processing returns to step ST211, and in a case where it is determined that the given condition is satisfied, the processing ends in step ST21. For example, the given condition may be a condition related to a dimension of the metal-containing resist film after step ST214. That is, after step ST214, it is determined whether the dimension of the metal-containing resist film (the thickness of the resist film) has reached a given value or range, and the cycle of step ST211 to step ST214 may be repeated until the given value or range is reached. The dimension of the metal-containing resist film may be measured with an optical measuring apparatus. As a result, the metal-containing resist film is formed on the underlying film UF.

### (CVD Method)

In an embodiment, in the CVD method, a mixed gas GM containing the metal-containing precursor and the polyfunctional compound is used to form the metal-containing resist film. The metal-containing precursor may include a known metal-containing precursor (in an example including Si, a silicon-containing compound or the like) that may be used in the CVD method, or may be the metal-containing precursor described in the ALD method. The polyfunctional compound may be the polyfunctional compound described in the ALD method. The mixed gas GM may include at least one selected from the group consisting of H₂O, H₂O₂, O₃, and O₂. In an embodiment, the mixed gas GM is supplied into the processing chamber 102 via the gas nozzle 141. The mixed gas GM chemically reacts on the substrate W, and thus the metal-containing resist film is formed on the underlying film UF.

In step ST2, the temperature and pressure of the substrate support 121 may be appropriately set. Adjustment of the temperature of the substrate support 121 may be performed by controlling one or more outputs of each heater. The temperature of the substrate support 121 may be, for example, 25°C to 350°C, and in an example, is 50°C to 200°C. The pressure in the processing chamber 102 may be, for example, 500 Torr or less.

In an embodiment, step ST2 may include a step of heating and baking the metal-containing resist film. The baking may be executed in an air atmosphere or may be executed in an inert atmosphere. The baking may be executed by heating the substrate W to 50°C or higher and 350°C or lower, 50°C or higher and 200°C or lower, or 80°C or higher and 150°C or lower. In an embodiment, each heater of the heating processing apparatus 100 may function as a heater for baking. In an embodiment, the baking may be executed using a heating processing system other than the heating processing apparatus 100.

In an embodiment, the present processing method may be executed by the dry process using the plasma processing system (see Figures 2 and 3). For example, the substrate W may be provided on the substrate support 11 in the processing chamber 10 of the plasma processing apparatus 1 (step ST1) and the metal-containing resist film RM may be formed by supplying the processing gas into the processing chamber 10 from the gas supply 20 (step ST2).

In a case where the plasma processing system is used, the above-described ALD method or CVD method may be used in step ST2. The configuration (the type, the flow rate, and the flow rate ratio) of the processing gas (the first gas G1, the second gas G2, the mixed gas GM, and the like) in step ST2, the temperature of the substrate support 11, and the like may be the same as those in a case where the heating processing system is used. The temperature of the substrate support 11 may be adjusted by controlling the pressure of the heat transfer gas (for example, He) between the temperature-controlled module or the electrostatic chuck 1111 and the back surface of the substrate W. In step ST21 and step ST22, the plasma may be formed from the processing gas, or the plasma may not be formed. As in the case of using the heating processing system (see Figure 1), step ST21 and/or step ST22 may include a step of heating the substrate W to perform the baking processing. The baking processing may be executed using, for example, the heating processing system.

In an embodiment, the present processing method may be executed by the wet process (wet film formation) using the liquid processing system (see Figure 4). That is, the substrate W may be provided on the spin chuck 311 in the processing chamber 310 of the liquid processing apparatus 300 (step ST1), and a solution for forming a film (resist precursor liquid) may be applied onto the substrate W from the processing liquid supply nozzle 331 to form the metal-containing resist film RM (step ST2). In an embodiment, in a case where step ST2 is carried out by the wet film formation, for example:
in the embodiment, the step (b) includes a step of applying a solution containing the metal-containing precursor and the polyfunctional compound onto the underlying film, and a step of heating the applied solution;
in the embodiment, the metal-containing precursor includes a metal complex containing at least one metal selected from the group consisting of Sn, Ti, Hf, Zr, and In;
in an embodiment, the polyfunctional compound includes at least one compound (β) selected from the group consisting of a polyalcohol, a polythiol, polycarboxylic acid, a polyisocyanate, and a polyisothiocyanate.

In a case where the liquid processing system is used, in step ST2, the solution for forming the film (resist precursor liquid) may contain the metal-containing precursor. In an embodiment, the metal-containing precursor includes the compound (α) having the amine group. In an embodiment, the compound (α) can include a compound (α1) including at least one metal selected from the group consisting of Sn, Ti, Hf, Zr, and In. In an embodiment, the compound (α1) can contain Sn. In an embodiment, the photosensitive group in the metal-containing precursor can include at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3). For example, the metal-containing precursor contains at least one compound selected from the group consisting of an aminotin compound, an aminotitanium compound, an aminohafnium compound, an aminozirconium compound, and an aminoindium compound. Examples of the aminotin compound may include n-butyltris(dimethylamino)tin, t-butyltris(dimethylamino)tin, bis(dimethylamino)dimethyltin, bis(dimethyl)dibutyltin, azidotrimethyltin, bis(dimethylamino)dibutyltin, and the like. Examples of the alkoxytin compound may include dimethyltin bis(tert-butoxide) and bis(dimethoxy)dimethyltin. Examples of the aminotitanium compound, the aminohafnium compound, and the aminozirconium compound may include a compound represented by a compositional formula of MRₓL_{y} (in the formula, M is Ti, Hf, or Zr, R is a photosensitive group, L is an amine group or an alkoxy group which may react with a polyfunctional compound, and x and y satisfy x ≥ 1 and y = 4 - x), and the like. Examples of the aminoindium compound may include a compound represented by a compositional formula of InRₓL_{y} (in the formula, R is a photosensitive group, L is an amine group or an alkoxy group which may react with a polyfunctional compound, and x and y satisfy x ≥ 1 and y = 3 - x), and the like.

In a case where the liquid processing system is used, in step ST2, the solution for forming the film (resist precursor liquid) may contain the polyfunctional compound. In an embodiment, the polyfunctional compound may include at least one compound (β) selected from the group consisting of a polyalcohol, a polythiol, a polycarboxylic acid, a polyisocyanate, and a polyisothiocyanate. Examples of the polyalcohol may include ethylene glycol, glycerin, and the like. Examples of the polythiol may include ethanedithiol, toluenedithiol, and the like. Examples of the polycarboxylic acid include glutaric acid, adipic acid, terephthalic acid (solution), and the like. Examples of the polyisocyanate may include toluene diisocyanate, and the like. Examples of the polyisothiocyanate may include butanediisothiocyanate, phenylene bis(isothiocyanate), and the like. The second gas G2 may include at least one selected from the group consisting of H₂O, H₂O₂, O₃, and O₂.

In a case where the liquid processing system is used, step ST2 may include a step of heating and baking the substrate W after the substrate W is coated with the solution. In an embodiment, the baking may be executed, for example, using the heating processing system (see Figure 1). The baking may be executed in an air atmosphere or may be executed in an inert atmosphere. The baking may be executed by heating the substrate W to 50°C or higher and 350°C or lower, 50°C or higher and 200°C or lower, or 80°C or higher and 150°C or lower.

In an embodiment, the film formation of the metal-containing resist film RM (Step ST2) in the present processing method may be performed by both the dry process using the heating processing system (see Figure 1) or the plasma processing system (see Figures 2 and 3) and the wet process using the liquid processing system (see Figure 4).

In an embodiment, by the reaction between the metal-containing precursor and the polyfunctional compound in step ST2, the metal-containing precursors are bonded to each other via a structure derived from the polyfunctional compound, and the composition ratio and the film density of the metal in the metal-containing resist film are reduced. The composition ratio and the film density of the metal are decreased, whereby in subsequent development, not only a substance having high reactivity (for example, a highly corrosive substance such as hydrogen chloride, boron chloride, or hydrogen bromide) but also, for example, an organic acid described later is sufficiently reacted, and a metal-containing resist film tends to be formed. In an embodiment, the metal-containing precursors are bonded to each other via the structure derived from the polyfunctional compound, whereby a chemical structure having a relatively weak bonding force, such as -Sn-X-A-X-Sn-(where, X and A are synonymous with those in Formula (1)), is obtained, and the film density is decreased, and in subsequent development, the reactivity tends to be improved, as compared with the bonding of -Sn-O-Sn- in the related art. In an embodiment, during the reaction between the metal-containing precursor and the polyfunctional compound is performed in step ST2, the type of the polyfunctional compound to be used over time can also be changed. As a specific example thereof, a polyfunctional compound having the first number of carbon atoms is used at the initial stage of the reaction (from the start of the reaction to the first elapsed time). Next, a polyfunctional compound having the second number of carbon atoms larger than the first number of carbon atoms is used in a medium stage of the reaction (from the first elapsed time to the second elapsed time). Further, in a later stage of the reaction (from the second elapsed time to the end of the reaction), a polyfunctional compound having the third number of carbon atoms larger than the second number of carbon atoms is used. In such an example, a metal-containing resist film having a composition and/or a density gradient in a film forming direction (the lower layer side has a high density (the composition ratio of the metal is high) and the upper layer side has a low density (the composition ratio of the metal is low)) is obtained. From the same viewpoint, another specific example thereof is that a polyfunctional compound having a first functional group is used at the initial stage of the reaction. Next, in the medium stage of the reaction, the polyfunctional compound having the second number of functional groups smaller than the first number of functional groups is used. Furthermore, the polyfunctional compound having the third number of functional groups smaller than the second number of functional groups is used in the later stage of the reaction. Even in such an example, the metal-containing resist film having the density gradient in the film forming direction (the lower layer side has a high density (the composition ratio of the metal is high) and the upper layer side has a low density (the composition ratio of the metal is low)) is obtained.

In the present processing method, even in a case where the processing method is carried out by the dry film formation or even in a case where the processing method is carried out by the wet film formation, in an embodiment, the present processing method can further include (c) a step of exposing the substrate after the step (b) to form an exposed first region and an unexposed second region on the metal-containing resist film, and (d) a step of developing the substrate to selectively remove the second region from the metal-containing resist film.

In an embodiment, in the (d) step, the second region can be removed by a development gas or a developer. In an embodiment, the development gas or the developer can contain an organic acid. In an embodiment, the organic acid can include at least one selected from the group consisting of an alcohol, a thiol, a carboxylic acid, a sulfonic acid, a β-dicarbonyl compound, an alkyl carbonate, and an azole, and in a case where these organic acids are employed, the contrast of development tends to be improved. Examples of the alcohol may include nonafluoro-tert-butyl alcohol ((CF₃)₃C-OH), trifluoroethanol, and the like. Examples of the thiol may include methanethiol, allyl mercaptan, trifluoroethanethiol, and the like. Examples of the carboxylic acid may include formic acid (HCOOH), acetic acid (CH₃COOH), trichloroacetic acid (CCl₃COOH), monofluoroacetic acid (CFH₂COOH), difluoroacetic acid (CF₂FCOOH), trifluoroacetic acid (CF₃COOH), chloro-difluoroacetic acid (CClF₂COOH), sulfur-containing acetic acid, thioacetic acid (CH₃COSH), thioglycolic acid (HSCH₂COOH), trifluoroacetic acid anhydride ((CF₃CO)₂O), acetic acid anhydride ((CH₃CO)₂O), and the like. Examples of the sulfonic acid may include methanesulfonic acid, fluorosulfonic acid, 10-camphorsulfonic acid, and the like. Examples of the β-dicarbonyl compound may include acetylacetone (CH₃C(O)CH₂C(O)CH₃), trichloroacetylacetone (CCl₃C(O)CH₂C(O)CH₃), hexachloroacetylacetone (CCl₃C(O)CH₂C(O)CCl₃), trifluoroacetylacetone (CF₃C(O)CH₂C(O)CH₃), hexafluoroacetylacetone (HFAc, CF₃C(O)CH₂C(O)CF₃), and the like. Examples of the alkyl carbonate may include dimethyl carbonate, and the like. Examples of the azole may include 1,2,3-triazole, and the like. The development gas or the developer can include an inorganic acid. In an embodiment, the development gas can include a halogen-containing gas. The halogen-containing gas may be a gas containing a halogen-containing inorganic acid, and may be a gas containing Br or Cl. The gas containing the halogen-containing inorganic acid is, for example, at least one selected from the group consisting of an HBr gas, a BCl₃ gas, an HCl gas, an HF gas, and an HI gas. In an embodiment, the processing gas is a mixed gas of a carboxylic acid and a hydrogen halide or a mixed gas of acetic acid and formic acid. In an embodiment, the developer may be a liquid containing the above-described halogen-containing inorganic acid.

In an embodiment, in the (d) step, the second region can be removed with a development gas or a developer containing a weak acid. In an embodiment, the weak acid can include an organic acid having an acid dissociation constant (pKa) of less than 16. For example, the organic acid having the acid dissociation constant (pKa) of less than 16 can be selected and used from the above-described organic acids. In an embodiment, the weak acid can include an organic acid having the acid dissociation constant (pKa) of 0 or more and less than 16. For example, the organic acid having the acid dissociation constant (pKa) of 0 or more and less than 16 can be selected and used from the above-described organic acids.

### (Composition for Forming Metal-containing Resist)

In an embodiment, in the present processing method, a composition for forming a metal-containing resist, which includes the metal-containing precursor having the photosensitive group and the polyfunctional compound, in which the metal-containing precursor includes the compound having the photosensitive group, an amine group, and/or an alkoxy group, can be used. The metal-containing precursor, the polyfunctional compound, and the like in the composition for forming the metal-containing resist may be the same as those described in step ST2. In an embodiment, the composition for forming the metal-containing resist can be a gas mixture of the gas containing the metal-containing precursor and the gas containing the polyfunctional compound. In an embodiment, the composition for forming the metal-containing resist can be a liquid mixture of the liquid containing the metal-containing precursor and the liquid containing the polyfunctional compound.

### (Metal-containing Resist)

In an embodiment, the metal-containing resist film obtained by the present processing method may include the following metal-containing resist. That is, in an embodiment, the metal-containing resist includes the compound having the repeating unit represented by the following Formula (1) in the molecule.

-(M-X-A-X)- (1)

(in Formula (1), M represents Sn, Ti, Hf, Zr, or In, X represents the divalent group derived from a terminal of the polyalcohol, the polythiol, the polycarboxylic acid, the polyisocyanate, or the polyisothiocyanate, and A represents the divalent organic group having the number of carbon atoms of 2 or more and 10 or less).

The polyalcohol, polythiol, polycarboxylic acid, polyisocyanate, and polyisothiocyanate, which may be given X in Formula (1), may be the same as those described in step ST2. In an example, the divalent group derived from the terminal of the polyalcohol includes an alkoxy bond. In an example, the divalent group derived from the terminal of the polythiol includes a sulfide bond. In an example, the divalent group derived from the terminal of the polycarboxylic acid includes an ester bond. In an example, the divalent group derived from the terminal of the polyisocyanate includes a urethane bond. In an example, the divalent group derived from the terminal of the polyisothiocyanate includes a thiourethane bond.

Examples of the divalent organic group which may be provided by A in Formula (1) include a hydrocarbon group g2 which has 2 or more and 10 or less carbon atoms and may be substituted. Examples of the hydrocarbon group g2 which may be substituted include a linear, branched, or cyclic divalent hydrocarbon group. Examples of the linear, branched, or cyclic divalent hydrocarbon group may include a linear, branched, or cyclic alkylene group or arylene group. In the linear, branched, or cyclic alkylene group or arylene group, at least one hydrogen atom in the molecule may be substituted with a halogen or the like.

### <Configuration Example of Substrate Processing System>

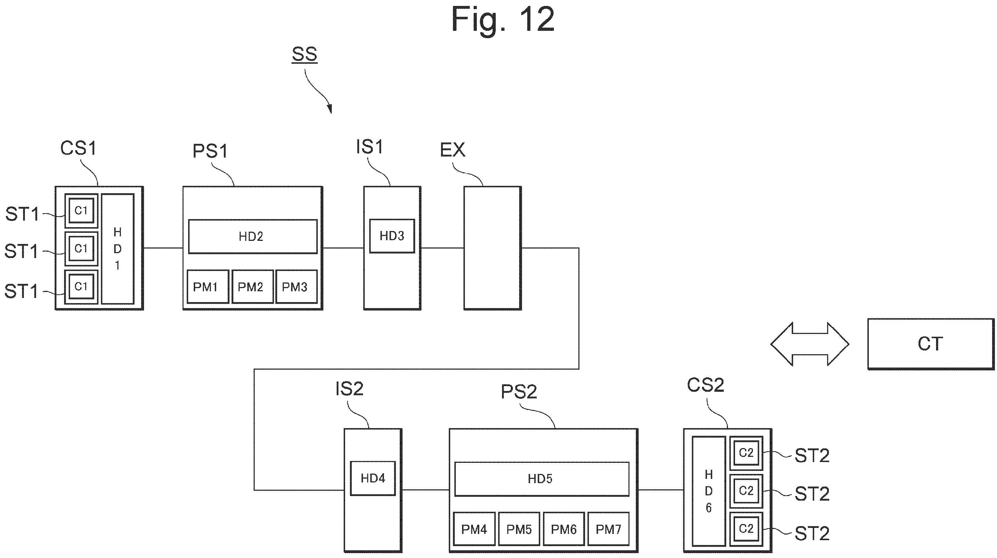

Figure 12 is a block diagram for describing a configuration example of a substrate processing system SS according to an exemplary embodiment. The substrate processing system SS includes a first carrier station CS1, a first processing station PS1, a first interface station IS1, an exposure apparatus EX, a second interface station IS2, a second processing station PS2, a second carrier station CS2, and a controller CT.

The first carrier station CS1 performs the carrying-in or carrying-out of the first carrier C1 between the first carrier station CS1 and an external system of the substrate processing system SS. The first carrier station CS1 has a stage including a plurality of first placing plates ST1. The first carrier C1 in a state where a plurality of substrates W is accommodated or in a state where the first carrier C1 is empty is placed on each first placing plate ST1. The first carrier C1 has a housing capable of accommodating the plurality of substrates W inside. In an example, the first carrier C1 is a front opening unified pod (FOUP).

In addition, the first carrier station CS1 transports the substrate W between the first carrier C1 and the first processing station PS1. The first carrier station CS1 further includes a first transport apparatus HD1. The first transport apparatus HD1 is provided at the first carrier station CS1 to be positioned between the stage and the first processing station PS1. The first transport apparatus HD1 transports and delivers the substrate W between the first carrier C1 on each first placing plate ST1 and the second transport apparatus HD2 of the first processing station PS1. The substrate processing system SS may further include a load lock module. The load lock module may be provided between the first carrier station CS1 and the first processing station PS1. The load lock module is able to switch the pressure inside thereof to atmospheric pressure or vacuum. The "atmospheric pressure" may be a pressure inside the first transport apparatus HD1. In addition, the "vacuum" is a pressure lower than the atmospheric pressure, and may be, for example, a medium vacuum of 0.1 Pa to 100 Pa. The inside of the second transport apparatus HD2 may be atmospheric pressure or vacuum. The load lock module may transport, for example, the substrate W from the first transport apparatus HD1, which is atmospheric pressure, to the second transport apparatus HD2, which is vacuum, and may transport the substrate W from the second transport apparatus HD2, which is vacuum, to the first transport apparatus HD1, which is atmospheric pressure.

The first processing station PS1 performs various types of processing on the substrate W. In an embodiment, the first processing station PS1 includes a preprocessing module PM1, a resist film forming module PM2, and a first heating processing module PM3 (hereinafter, also collectively referred to as a "first substrate processing module PMa"). In addition, the first processing station PS1 has a second transport apparatus HD2 that transports the substrate W. The second transport apparatus HD2 transports and delivers the substrate W between two designated first substrate processing modules PMa and between the first processing station PS1 and the first carrier station CS1 or the first interface station IS1.

In the preprocessing module PM1, the substrate W is subjected to the preprocessing. In an embodiment, the preprocessing module PM1 includes a temperature-controlled unit that adjusts the temperature of the substrate W, a high-precision temperature controlled unit that adjusts the temperature of the substrate W with high precision, and an underlying film forming unit that forms a part or all of the underlying film on the substrate W. In an embodiment, the preprocessing module PM1 includes a surface reforming unit that performs surface reforming processing on the substrate W. Each processor of the preprocessing module PM1 may be configured to include the heating processing apparatus 100 (see Figure 1), the plasma processing apparatus 1 (see Figures 2 and 3), and/or the liquid processing apparatus 300 (see Figure 4).

In the resist film forming module PM2, the resist film is formed on the substrate W. In an embodiment, the resist film forming module PM2 includes a dry coating unit. The dry coating unit forms the resist film on the substrate W using a dry process such as a vapor deposition method. The dry coating unit includes, for example, a CVD apparatus or ALD apparatus that performs chemical vapor deposition on the resist film, or a PVD apparatus that performs physical vapor deposition on the resist film on the substrate W disposed in the chamber. The dry coating unit may be the heating processing apparatus 100 (see Figure 1) or the plasma processing apparatus 1 (see Figures 2 and 3).

In an embodiment, the resist film forming module PM2 includes a wet coating unit. The wet coating unit forms the resist film on the substrate W using a wet process such as a liquid phase deposition method. The wet coating unit may be, for example, the liquid processing apparatus 300 (see Figure 4).

In an embodiment, the example of the resist film forming module PM2 includes both the wet coating unit and the dry coating unit.

In the first heating processing module PM3, the substrate W is subjected to the heating processing. In an embodiment, the first heating processing module PM3 includes any one or more of a pre-baking (post apply bake: PAB) unit that performs the heating processing on the substrate W on which the resist film is formed, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In an example, the plurality of heating processing apparatuses may be stacked. The heating processing apparatus may be, for example, the heating processing apparatus 100 (see Figure 1). Each heating processing may be performed at a predetermined temperature using a predetermined gas.

The first interface station IS1 includes a third transport apparatus HD3. The third transport apparatus HD3 transports and delivers the substrate W between the first processing station PS1 and the exposure apparatus EX. The third transport apparatus HD3 may be configured to have a housing that accommodates the substrate W, and a temperature, humidity, pressure, and the like in the housing are controllable.

In the exposure apparatus EX, the resist film on the substrate W is exposed using an exposure mask (reticle). The exposure apparatus EX may be, for example, an EUV exposure apparatus having a light source that generates EUV light.

The second interface station IS2 includes a fourth transport apparatus HD4. The fourth transport apparatus HD4 transports or delivers the substrate W between the exposure apparatus EX and the second processing station PS2. The fourth transport apparatus HD4 may be configured to have a housing that accommodates the substrate W, and the temperature, humidity, pressure, and the like in the housing may be controllable.

The second processing station PS2 performs various types of processing on the substrate W. In an embodiment, the second processing station PS2 includes a second heating processing module PM4, a measurement module PM5, a developing module PM6, and a third heating processing module PM7 (hereinafter, also collectively referred to as a "second substrate processing module PMb"). In addition, the second processing station PS2 has a fifth transport apparatus HD5 that transports the substrate W. The fifth transport apparatus HD5 transports and delivers the substrate W between the two designated second substrate processing modules PMb and between the second processing station PS2 and the second carrier station CS2 or the second interface station IS2.

In the second heating processing module PM4, the substrate W is subjected to the heating processing. In an embodiment, the heating processing module PM4 includes any one or more of a post-exposure baking (post exposure bake: PEB) unit that performs the heating processing on the substrate W after exposure, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In an example, the plurality of heating processing apparatuses may be stacked. The heating processing apparatus may be, for example, the heating processing apparatus 100 (see Figure 1). Each heating processing may be performed at a predetermined temperature using a predetermined gas.

In the measurement module PM5, various measurements are performed on the substrate W. In an embodiment, the measurement module PM5 includes an imaging unit including a stage on which the substrate W is placed, an imaging apparatus, an illumination apparatus, and various sensors (a temperature sensor, a reflectivity measuring sensor, and the like). The imaging apparatus may be, for example, a CCD camera that images the appearance of the substrate W. Alternatively, the imaging apparatus may be a hyperspectral camera that images light by spectrally separating the light for each wavelength. The hyperspectral camera may measure any one or more of a pattern shape, a dimension, a film thickness, a composition, and a film density of the resist film.

In the developing module PM6, the substrate W is subjected to development processing. In an embodiment, the developing module PM6 includes a dry development unit that performs dry development on the substrate W. The dry development unit may be, for example, the heating processing apparatus 100 (see Figure 1) or the plasma processing apparatus 1 (see Figures 2 and 3). In an embodiment, the developing module PM6 includes a wet development unit that performs wet development on the substrate W. The wet development unit may be, for example, the liquid processing apparatus 300 (Figure 4). In an embodiment, the developing module PM6 includes both the dry development unit and the wet development unit.

In the third heating processing module PM7, the substrate W is subjected to the heating processing. In an embodiment, the third heating processing module PM7 includes any one or more of a post-bake (PB) unit that performs heating processing on the substrate W after development, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In an example, the plurality of heating processing apparatuses may be stacked. The heating processing apparatus may be, for example, the heating processing apparatus 100 (see Figure 1). Each heating processing may be performed at a predetermined temperature using a predetermined gas.

The second carrier station CS2 performs the carrying-in and carrying-out of the second carrier C2 between the second carrier station CS2 and an external system of the substrate processing system SS. The configuration and the function of the second carrier station CS2 may be the same as those of the first carrier station CS1 described above.

The controller CT controls each configuration of the substrate processing system SS to execute given processing on the substrate W. The controller CT stores a recipe in which a process procedure, a process condition, a transport condition, and the like are set, and controls each configuration of the substrate processing system SS to execute given processing on the substrate W according to the recipe. The controller CT may serve as some or all of the functions of each controller (the controller 200 and the controller 2 illustrated in Figures 1 to 4 and the controller 400).

### <Example of Substrate Processing Method>

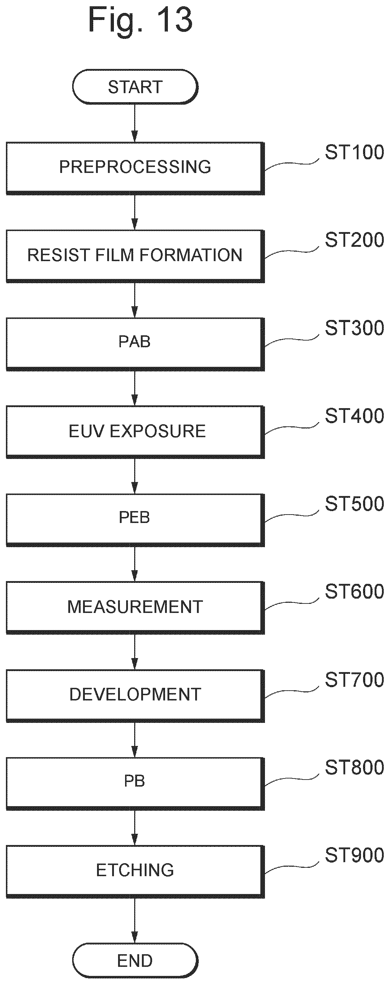

Figure 13 is a flowchart illustrating a substrate processing method (hereinafter, also referred to as a "method MT") according to an exemplary embodiment. As illustrated in Figure 13, the method MT includes step ST100 of performing preprocessing on the substrate, step ST200 of forming the resist film on the substrate, step ST300 of performing heating processing (pre-baking: PAB) on the substrate on which the resist film is formed, step ST400 of performing EUV exposure on the substrate, step ST500 of performing heating processing (post-exposure baking: PEB) on the substrate after the exposure, step ST600 of measuring the substrate, step ST700 of developing the resist film of the substrate, step ST800 of performing heating processing (post-baking: PB) on the substrate after the development, and step ST900 of etching the substrate. The method MT may not include one or more of the above-described each step. For example, the method MT may not include step ST600, and step ST700 may be executed after step ST500.

The method MT may be executed by using the substrate processing system SS illustrated in Figure 12. In the following, a case where the controller CT of the substrate processing system SS controls each unit of the substrate processing system SS to execute the method MT on the substrate W will be described as an example.

### (Step ST100: Preprocessing)

First, the first carrier C1 accommodating the plurality of substrates W is carried into the first carrier station CS1 of the substrate processing system SS. The first carrier C1 is placed on the first placing plate ST1. Next, each substrate W in the first carrier C1 is sequentially taken out by the first transport apparatus HD1 and delivered to the second transport apparatus HD2 of the first processing station PS1. The substrate W is transported to the preprocessing module PM1 by the second transport apparatus HD2. The preprocessing module PM1 performs the preprocessing on the substrate W. The preprocessing may include, for example, one or more of temperature adjustment of the substrate W, formation of a part or all of the underlying film of the substrate W, heating processing of the substrate W, and high-precision temperature adjustment of the substrate W. The preprocessing may include a surface reforming processing of the substrate W, as another example.

### (Step ST200: Resist Film Formation)

Next, the substrate W is transported to the resist film forming module PM2 by the second transport apparatus HD2. The resist film is formed on the substrate W by the resist film forming module PM2. In an embodiment, the resist film is formed by a wet process such as a liquid phase deposition method. For example, the resist film is formed by spin-coating the resist film on the substrate W using the wet coating unit of the resist film forming module PM2. In an embodiment, the resist film is formed on the substrate W by a dry process such as a vapor deposition method.

For example, the resist film is formed by vapor-depositing the resist film on the substrate W using the dry coating unit of the resist film forming module PM2. The resist film may be formed in step ST200 by using the present processing method (see Figure 5). That is, the metal-containing resist film RM may be formed on the substrate W.

The resist film may be formed on the substrate W by using both the dry process and the wet process. For example, the second resist film may be formed on the first resist film by the wet process after the first resist film is formed on the substrate W by the dry process. In this case, the film thicknesses, materials, and/or compositions of the first resist film and the second resist film may be the same as or different from each other.

### (Step ST300: PAB)

Next, the substrate W is transported to the first heating processing module PM3 by the second transport apparatus HD2. The substrate W is subjected to the heating processing (pre-baking: PAB) by the first heating processing module PM3. The pre-baking may be performed in an air atmosphere or an inert atmosphere. In addition, the pre-baking may be performed by heating the substrate W to 50°C or higher or 80°C or higher. The heating temperature of the substrate W may be 250°C or lower, 200°C or lower, or 150°C or lower. In an example, the heating temperature of the substrate may be 50°C or higher and 250°C or lower. In a case where the resist film is formed by the dry process in step ST200, in an embodiment, the pre-baking may be continuously executed by the dry coating unit that has executed step ST200. In an embodiment, after the pre-baking, removing processing of the resist film at the end portion of the substrate W (edge bead removal: EBR) may be performed.

### (Step ST400: EUV Exposure)

Next, the substrate W is delivered to the third transport apparatus HD3 of the first interface station IS1 by the second transport apparatus HD2. Then, the substrate W is transported to the exposure apparatus EX by the third transport apparatus HD3. The substrate W is subjected to EUV exposure in the exposure apparatus EX via the exposure mask (reticle). The EUV has, for example, a wavelength in a range of 10 to 20 nm. The EUV may have a wavelength in a range of 11 to 14 nm, and has a wavelength of 13.5 nm in an example. As a result, on the substrate W, a first region where EUV exposure is performed and a second region where EUV exposure is not performed are formed corresponding to the pattern of the exposure mask (reticle). In an embodiment, the film thickness of the first region may be smaller than the film thickness of the second region 2.

### (Step ST500: PEB)

Next, the substrate W is delivered from the fourth transport apparatus HD4 of the second interface station IS2 to the fifth transport apparatus HD5 of the second processing station PS2. Then, the substrate W is transported to the second heating processing module PM4 by the fifth transport apparatus HD5. Then, the substrate W is subjected to the heating processing (post-exposure baking: PEB) in the second heating processing module PM4. The post-exposure baking may be performed in the air atmosphere. In addition, the post-exposure baking may be performed by heating the substrate W to 180°C or higher and 250°C or lower.

### (Step ST600: Measurement)

Next, the substrate W is transported to the measurement module PM5 by the fifth transport apparatus HD5. The measurement module PM5 measures the substrate W. The measurement may be an optical measurement or other measurements. In an embodiment, the measurement by the measurement module PM5 includes measurement of the appearance and/or dimensions of the substrate W using a CCD camera. In an embodiment, the measurement by the measurement module PM5 includes the measurement of any one or more of a pattern shape, a dimension, a film thickness, a composition, or a film density of a resist film using a hyperspectral camera (hereinafter, also referred to as "pattern shape and the like").

In an embodiment, the controller CT determines the presence or absence of the exposure abnormality of the substrate W based on the measured appearance, dimensions, and/or pattern shape, and the like of the substrate W. In an embodiment, in a case where the controller CT determines that there is an exposure abnormality, the substrate W may be reworked or discarded without performing the development in step ST700. The rework of the substrate W may be performed by removing the resist on the substrate W and returning to step ST200 to form the resist film again. The rework after development may cause damage to the substrate W, but damage to the substrate W may be avoided or suppressed by performing the rework before development.

### (Step ST700: Development)

Next, the substrate W is transported to the developing module PM6 by the fifth transport apparatus HD5. In the developing module PM6, the resist film of the substrate W is developed. Any of the first region exposed to EUV or the second region not exposed to EUV is selectively removed by development. The development processing may be performed by the dry development or the wet development. The development processing may be performed by combining the dry development and the wet development. Desorption processing may be executed once or more after the development processing or during the development processing. The desorption processing includes removing (descumming) a scum from the surface of the resist film or smoothing the surface with an inert gas such as helium or plasma of the inert gas. The development processing may be performed by heating the substrate W to 100°C or higher and 350°C or lower. The dry development processing may be performed by setting the pressure to 10 Torr or less. The development processing may be performed for 0.5 minutes or more and 2 hours or less. As described above, in an embodiment, the present processing method can also be carried out as a part of the developing method. That is, in an embodiment, the developing method includes (a) a step of providing a substrate including an underlying film and a metal-containing resist on the underlying film, (b) a step of exposing the metal-containing resist via an exposure mask and forming an exposed first region and an unexposed second region in the metal-containing resist, and (c) a step of selectively removing one of the first region and the second region, in which the metal-containing resist in (a) contains a compound having a repeating unit represented by Formula (1) in a molecule.

### (Step ST800: PB)

Next, the substrate W is transported to the third heating processing module PM7 by the fifth transport apparatus HD5 and is subjected to the heating processing (post-baking). The post-baking may be performed in an air atmosphere or a reduced pressure atmosphere containing N₂ or O₂. In addition, the post-baking may be performed by heating the substrate W to 150°C or higher and 250°C or lower. The post-baking may be performed by the second heating processing module PM4 instead of the third heating processing module PM7. In an embodiment, the optical measurement of the substrate W may be performed by the measurement modules PM4 and PM5 after the post-baking. Such measurement may be executed in addition to the measurement in step ST600 or instead of the measurement in step ST600. In an embodiment, the controller CT determines the presence or absence of an abnormality or the like such as a defect, a scratch, or an adhesion of a foreign substance in the development pattern of the substrate W based on the measured appearance and dimensions of the substrate W and/or the pattern shape, and the like. In an embodiment, in a case where the controller CT determines that an abnormality has occurred, the substrate W may be reworked or discarded without performing the etching in step ST900. In an embodiment, in a case where the controller CT determines that an abnormality is present, the opening dimensions of the resist film of the substrate W may be adjusted by using the dry coating unit (CVD apparatus, ALD apparatus, or the like).

### (Step ST900: Etching)

After the execution of step ST800, the substrate W is delivered to the sixth transport apparatus HD6 of the second carrier station CS2 by the fifth transport apparatus HD5, and is transported to the second carrier C2 of the second placing plate ST2 by the sixth transport apparatus HD6. Thereafter, the second carrier C2 is transported to a plasma processing system (not illustrated). The plasma processing system may be, for example, the plasma processing system illustrated in Figures 2 and 3. In the plasma processing system, the underlying film UF of the substrate W is etched using the resist film after development as a mask. As described above, the method MT ends. In a case where the resist film is developed using a plasma processing apparatus in step ST700, the etching may be continuously executed in the plasma processing chamber of the plasma processing apparatus. In addition, in a case where the second processing station PS2 includes a plasma processing module in addition to the developing module PM6, the etching may be executed in the plasma processing module. The above-described desorption processing may be executed once or more before or during the etching. As described above, in an embodiment, the present processing method can also be carried out as a part of the etching method. That is, in an embodiment, the method includes (a) a step of providing a substrate including an underlying film and a metal-containing resist on the underlying film, in which the metal-containing resist has at least one opening, and (b) a step of etching the underlying film via the opening, in which the metal-containing resist contains a compound having a repeating unit represented by Formula (1) in a molecule.

The embodiments of the present disclosure further include the following aspects.

### (Addendum 1)

A substrate processing method including:
(a) providing a substrate including an underlying film; and
(b) forming a metal-containing resist film on the underlying film by using a metal-containing precursor and a polyfunctional compound, the metal-containing precursor having a photosensitive group.

### (Addendum 2)

The substrate processing method according to Addendum 1, in which the metal-containing precursor includes a compound (α) having an amine group and/or an alkoxy group.

### (Addendum 3)

The substrate processing method according to Addendum 2, in which the compound (α) includes a compound (α1) including at least one metal selected from the group consisting of Sn, Ti, Hf, Zr, and In.

### (Addendum 4)

The substrate processing method according to Addendum 3, in which the compound (α1) includes Sn.

### (Addendum 5)

The substrate processing method according to any one of Addendums 1 to 4, in which the photosensitive group includes at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3).

### (Addendum 6)

The substrate processing method according to any one of Addendums 1 to 5, in which the polyfunctional compound includes at least one compound (β) selected from the group consisting of a polyalcohol, a polythiol, a polycarboxylic acid, a polyisocyanate, and a polyisothiocyanate.

### (Addendum 7)

The substrate processing method according to any one of Addendums 1 to 6, in which in the (b), at least one selected from the group consisting of H₂O, H₂O₂, O₃, and O₂ is further used.

### (Addendum 8)

The substrate processing method according to any one of Addendums 1 to 7, in which the (b) includes
(b1) supplying a gas including the metal-containing precursor to the underlying film to form a metal-containing precursor film, and
(b2) supplying a gas including the polyfunctional compound to the metal-containing precursor film to form the metal-containing resist film from the metal-containing precursor film.

### (Addendum 9)

The substrate processing method according to Addendum 8, in which the (b1) and the (b2) are repeated a plurality of times.

### (Addendum 10)

The substrate processing method according to any one of Addendums 1 to 9, in which the (b) includes forming the metal-containing resist film using a mixed gas including the metal-containing precursor and the polyfunctional compound.

### (Addendum 11)

The substrate processing method according to any one of Addendums 1 to 10, in which the metal-containing precursor includes a metal complex containing at least one metal selected from the group consisting of Sn, Ti, Hf, Zr, and In.

### (Addendum 12)

The substrate processing method according to any one of Addendums 1 to 11, in which the polyfunctional compound includes at least one compound (β) selected from the group consisting of a polyalcohol, a polythiol, a polycarboxylic acid, a polyisocyanate, and a polyisothiocyanate.

### (Addendum 13)

The substrate processing method according to any one of Addendums 1 to 12, in which the (b) includes
applying a solution containing the metal-containing precursor and the polyfunctional compound onto the underlying film, and
heating the applied solution to form the metal-containing resist film.

### (Addendum 14)

The substrate processing method according to any one of Addendums 1 to 13, further including:
(c) exposing, after the (b), the substrate to form an exposed first region and an unexposed second region on the metal-containing resist film; and
(d) developing the substrate to selectively remove the second region from the metal-containing resist film.

### (Addendum 15)

The substrate processing method according to Addendum 14, in which in the (d), the second region is removed with a development gas or a developer containing a weak acid.

### (Addendum 16)

The substrate processing method according to Addendum 15, in which the weak acid includes an organic acid having an acid dissociation constant (pKa) of less than 16.

### (Addendum 17)

The substrate processing method according to Addendum 16, in which the organic acid includes at least one selected from the group consisting of an alcohol, a thiol, a carboxylic acid, a sulfonic acid, a β-dicarbonyl compound, an alkyl carbonate, and an azole.

### (Addendum 18)

A composition for forming a metal-containing resist, including:
a metal-containing precursor having a photosensitive group; and
a polyfunctional compound, in which
the metal-containing precursor includes a compound having the photosensitive group, an amine group, and/or an alkoxy group.

### (Addendum 19)

A metal-containing resist including:
a compound having a repeating unit represented by the following Formula (1) in a molecule,

   -(M-X-A-X)- (1)
(in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

### (Addendum 20)

A substrate processing system including:
one or a plurality of substrate processing apparatuses; and
a controller, in which
the controller is configured to execute, with respect to the one or the plurality of substrate processing apparatuses,
   (a) providing a substrate including an underlying film, and
   (b) forming a metal-containing resist film on the underlying film by using a metal-containing precursor and a polyfunctional compound, the metal-containing precursor having a photosensitive group.

### (Addendum 21)

A device manufacturing method including:
(a) providing a substrate including an underlying film; and
(b) forming a metal-containing resist film on the underlying film by using a metal-containing precursor having a photosensitive group and a polyfunctional compound.

### (Addendum 22)

A program for causing a computer of a substrate processing system including one or a plurality of substrate processing apparatuses and a controller to execute:
(a) providing a substrate including an underlying film; and
(b) forming a metal-containing resist film on the underlying film by using a metal-containing precursor having a photosensitive group and a polyfunctional compound.

### (Addendum 23)

A storage medium in which the program according to Addendum 22 is stored.

### (Addendum 24)

A developing method including:
(a) providing a substrate including an underlying film and a metal-containing resist on the underlying film;
(b) exposing the metal-containing resist via an exposure mask to form an exposed first region and an unexposed second region on the metal-containing resist; and
(c) selectively removing one of the first region and the second region, in which the metal-containing resist in the (a) contains a compound having a repeating unit represented by the following Formula (1) in a molecule,

   -(M-X-A-X)- (1)

   (in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

### (Addendum 25)

An etching method including:
(a) providing a substrate including an underlying film and a metal-containing resist on the underlying film, in which the metal-containing resist has at least one opening; and
(b) etching the underlying film via the opening, in which
   the metal-containing resist contains a compound having a repeating unit represented by the following Formula (1) in a molecule,

      -(M-X-A-X)- (1)
   (in Formula (1), M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having the number of carbon atoms of 2 or more and 10 or less).

Each of the above embodiments is described for the purpose of description, and is not intended to limit the scope of the present disclosure. Each of the above embodiments may be modified in various ways without departing from the scope and purpose of the present disclosure. For example, some configuration elements in one embodiment are able to be added to other embodiments. In addition, some configuration elements in one embodiment are able to be replaced with corresponding configuration elements in another embodiment.

### Reference Signs List

1 ... plasma processing apparatus, 2 ... controller, 10 ... plasma processing chamber, 11 ... substrate support, 20 ... gas supply, 30 ... power supply, 100 ... heating processing apparatus, 102 ... processing chamber, 120 ... stage heater, 121 ... substrate support, 141 ... gas nozzle, 200 ... controller, 300 ... liquid, processing apparatus, 311 ... spin chuck, 321 ... cup, 331 ... processing liquid, supply nozzle, 351 ... cleaning liquid supply nozzle, 400 ... controller, RM ... metal-containing resist film, UF ... underlying film, W ... substrate

## Claims

1. A substrate processing method comprising:
(a) providing a substrate, the substrate including an underlying film; and
(b) forming a metal-containing resist film on the underlying film by using a metal-containing precursor and a polyfunctional compound, the metal-containing precursor having a photosensitive group.

2. The substrate processing method according to Claim 1, wherein the metal-containing precursor includes a compound (α) having an amine group and/or an alkoxy group.

3. The substrate processing method according to Claim 2, wherein the compound (α) includes a compound (α1) including at least one metal selected from the group consisting of Sn, Ti, Hf, Zr, and In.

4. The substrate processing method according to Claim 3, wherein the compound (α1) includes Sn.

5. The substrate processing method according to Claim 1, wherein the photosensitive group includes at least one group selected from the group consisting of a methyl group, an ethyl group, an n-propyl group, an n-butyl group, an i-propyl group, a t-butyl group, and -CHₓF_{y} (where, x represents an integer of 0 to 2, and y represents an integer of 1 to 3).

6. The substrate processing method according to Claim 2, wherein the polyfunctional compound includes at least one compound (β) selected from the group consisting of a polyalcohol, a polythiol, a polycarboxylic acid, a polyisocyanate, and a polyisothiocyanate.

7. The substrate processing method according to Claim 1, wherein in the (b), at least one selected from the group consisting of H₂O, H₂O₂, O₃, and O₂ is further used.

8. The substrate processing method according to Claim 1, wherein the (b) includes
(b1) supplying a gas including the metal-containing precursor to the underlying film to form a metal-containing precursor film, and
(b2) supplying a gas including the polyfunctional compound to the metal-containing precursor film to form the metal-containing resist film from the metal-containing precursor film.

9. The substrate processing method according to Claim 8, wherein the (b1) and the (b2) are repeated a plurality of times.

10. The substrate processing method according to Claim 1, wherein the (b) includes forming the metal-containing resist film using a mixed gas including the metal-containing precursor and the polyfunctional compound.

11. The substrate processing method according to Claim 1, wherein the metal-containing precursor includes a metal complex containing at least one metal selected from the group consisting of Sn, Ti, Hf, Zr, and In.

12. The substrate processing method according to Claim 11, wherein the polyfunctional compound includes at least one compound (β) selected from the group consisting of a polyalcohol, a polythiol, a polycarboxylic acid, a polyisocyanate, and a polyisothiocyanate.

13. The substrate processing method according to Claim 11, wherein the (b) includes
applying a solution containing the metal-containing precursor and the polyfunctional compound onto the underlying film, and
heating the applied solution to form the metal-containing resist film.

14. The substrate processing method according to Claim 1, further comprising:
(c) exposing, after the (b), the substrate to form an exposed first region and an unexposed second region on the metal-containing resist film; and
(d) developing the substrate to selectively remove the second region from the metal-containing resist film.

15. The substrate processing method according to Claim 14, wherein in the (d), the second region is removed with a development gas or a developer containing a weak acid.

16. The substrate processing method according to Claim 15, wherein the weak acid includes an organic acid having an acid dissociation constant, pKa, of less than 16.

17. The substrate processing method according to Claim 16, wherein the organic acid includes at least one selected from the group consisting of an alcohol, a thiol, a carboxylic acid, a sulfonic acid, a β-dicarbonyl compound, an alkyl carbonate, and an azole.

18. A composition for forming a metal-containing resist, comprising:
a metal-containing precursor having a photosensitive group; and
a polyfunctional compound, wherein
the metal-containing precursor includes a compound having the photosensitive group, an amine group, and/or an alkoxy group.

19. A metal-containing resist comprising:
a compound having a repeating unit represented by the following Formula (1) in a molecule,
-(M-X-A-X)- (1)
wherein, M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having 2 or more and 10 or less of carbon atoms.

20. A substrate processing system comprising:
one or a plurality of substrate processing apparatuses; and
a controller, wherein
the controller is configured to execute, with respect to the one or the plurality of substrate processing apparatuses,
(a) providing a substrate including an underlying film, and
(b) forming a metal-containing resist film on the underlying film by using a metal-containing precursor and a polyfunctional compound, the metal-containing precursor having a photosensitive group.

21. A developing method comprising:
(a) providing a substrate, the substrate including an underlying film and a metal-containing resist on the underlying film;
(b) exposing the metal-containing resist via an exposure mask to form an exposed first region and an unexposed second region in the metal-containing resist; and
(c) selectively removing one of the first region and the second region, wherein the metal-containing resist in the (a) contains a compound having a repeating unit represented by the following Formula (1) in a molecule,
-(M-X-A-X)- (1)
wherein, M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having 2 or more and 10 or less of carbon atoms.

22. An etching method comprising:
(a) providing a substrate, the substrate including an underlying film and a metal-containing resist on the underlying film, in which the metal-containing resist has at least one opening; and
(b) etching the underlying film via the opening, wherein
the metal-containing resist contains a compound having a repeating unit represented by the following Formula (1) in a molecule,
-(M-X-A-X)- (1)
wherein, M represents Sn, Ti, Hf, Zr, or In, X represents a divalent group derived from a terminal functional group of a polyalcohol, a polythiol, a polycarboxylic acid, a polyisocyanate, or a polyisothiocyanate, and A represents a divalent organic group having 2 or more and 10 or less of carbon atoms.
